# EUROPEAN PATENT APPLICATION

(11) **EP 2 871 555 A1**
(43) Date of publication of application: **13.05.2015**
(21) Application number: 13813742.7
(22) Date of filing: 28.06.2013
(51) Int. Cl.: G06F 3/023, H03M 11/04, H03M 11/10, H03M 11/12, H03M 11/14, H03M 11/22, H04M 1/00

(54) **INTEGRATED INPUT METHOD FOR WESTERN EUROPEAN LANGUAGES IN PORTABLE INPUT ELECTRONIC APPARATUS**

(30) Priority: 03.07.2012 JP 2012162049; 12.07.2012 JP 2012170431; 02.05.2013 JP 2013097169
(71) Applicant: Satake, Yasuhiko, Kanagawa 248-0025 (JP)
(72) Inventor: Satake, Yasuhiko, Kanagawa 248-0025 (JP)
(74) Representative: Nederlandsch Octrooibureau
(86) International application number: PCT/JP2013/068449
(87) International publication number: WO 2014/007356

(57) **Abstract**

Current input methods for Western European portable input electronic apparatuses accommodate only phonemes of Western European languages; however, they do not accommodate the phoneme structures of the same. In the present invention, by performing setting so that, for a number of keys , one key is assigned input for a plurality of alphabet letters in a form which accommodates the entirety of phoneme structures of Western European languages, for across all Western European languages. It is then possible to input the same content as with a current personal computer in methods which use a 3 row, 3 column keyboard and switch keyboards manually, with approximately a 30% increase keystrokes, and in methods which use a 3 row, 5 column keyboard and do not switch keyboards, with approximately a 10% increase in keystrokes. In methods which use a 3 row, 3 column keyboard and determine a input result in accordance with a dictionary, it is possible to input the same content with approximately a 25% increase in keystrokes, and in the case of a similar 3 row, 5 column keyboard, with a similar number of keystrokes as with a current personal computer.

## Description

### Technical Field

The present invention relates to the field of arrangement of characters or letters on the alphabetical keyboard of portable input electronic apparatus, which enables user to input all European languages with singular type of keyboard.

This invention defines portable input electronic apparatus as the apparatus with terminal keyboard which contains less than 15 keys for characters..

### Background Art

Today, portable input electronic apparatus owing to remarkable development of semiconducter industry, already has much higher function than that of the early days personal computer.

So, portable input electronic apparatus ought to be equipped with high operability in inputting and editing characters or in accessing Internet, at least higher than that of the early days personal computer.

But the actual inputing method of mobile phone does not fully correspond to these needs.

Especially, there is a remarkable difference in operability to input characters or letters between European languages and Japanese language.

It is a well-known fact that e-mail through portable input electronic apparatus is not so common in Western countries and is very popular in Japan to the extent to be ridiculed as Galapagos phenomena.

This ridicule considers popularity of e-mail in Japan to be based on the peculiar characteristics of Japanese people.

But we had better observe the problem more definitely noting the concrete process of inputting characters.

Generally speaking, the alphabetic keyboard of Western languages provides 8 keys and 3 or 4 characters are assigned to each key, and there are 26 types of keystroke.

The variation of key touch for each key is distributed from 1 to 3 times for 6 keys and 1 to 4 times for 2 keys.

The Japanese inputting is done according to so called Fifty-sounds-table.

The Fifty-sounds-table is a Japanese syllabary reflecting Japanese phonologic structure, which is composed of 5 vowels and 9 consonants and the combination of each consonant and vowel composes certain Japanese syllable.

Specifically, the table contains 1 line of vowel,aiueo, and 9 lines of combination of certain consonant and certain vowel.

Thus, Japanese inputting of portable input electronic apparatus uses 10 keys and each key assumes charge of each line, though the table contains some blanks and actually used characters are 46.

For example, basic consonant k combined with 5 vowels is called k-line and the key charged with k-line types 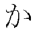 or ka, when it is pressed once, 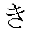 or ki, when it is pressed twice successively,
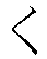 or ku, when it is pressed thrice successively, 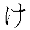 or ke, when it is pressed four times successively, 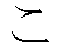 or ko, when it is pressed five times successively.

Thus 46 basic characters are assigned to 10 keys in the standard method of Japanese inputting, but it is needed to prepare small characters to represent double consonant. There are also contracted sounds, voiced consonants and so called p-sounds. All the characters reach 80 in Japanese and the corresponding keystrokes also reach 80 sorts.

More specifically, a-line key is pressed 10 times, 5 times to represent ordinary characters and other 5 times to represent small characters, t-line key is pressed 5 times to represent ordinary characters and other 1 time to represent small characters, 5 times to represent relating voiced consonant, y-line key is pressed 3 times to represent ordinary characters and another 3 times to represent small characters, each k-line key, s-line key is pressed 5 times to represent ordinary characters and other 5 times to represent relating voiced consonant, h-line key is pressed 5 times to represent ordinary characters and other 5 times to represent relating voiced consonant, 5 times to represent so-called p-sound, n-line key, r-line key, m-line key is pressed 5 times, w-line key is pressed 3 times, so, 80 key-strokes are needed to input Japanese in total.

Moreover, in the case of Japanese inputting, a frequency of pressing down of each key is distributed from 1 time to 10 times, sometimes regularly, sometimes irregularly.

Seen from the standpoint of mechanical operation, Japanese inputting is remarkably complicated and difficult. It should be almost impossible for a man who does not know Japanese to input it with alphabetical keyboard.

On the contrary, it is not difficult for a man who does not know Western languages to input them with alphabetical keyboard.

It is rather curious, still e-mail through portable input electronic apparatuss is at low level in Western countries and is much popular in Japan

From the standpoint of the present invention, the ultimate reason causing this difference should be attributed to the contrasting phase of the human-interface of each method.

And the basic element causing this difference between these two methods is the extent of the reflection of phonologic structure of concerned language in each method.

That is to say, Japanese inputting method almost totally reflects the Japanese phonologic structure through adopting so-called Fifty-sounds-table, while Western inputting method only reflects phonologic sound and does not reflect phonologic structure of concerned language.

In other words, Japanese inputting method only can be used in inputting Japanese and is not able to input other languages and Western inputting method can be used in inputting all the European languages and also can be applied to input many Asian languages, because this method only reflects phonologic sound of concerned language and does not reflect phonologic structure of concerned language.

Then, if we can rearrange alphabetical inputting method to be new method, which allows reflecting the phonologic structure of concerned language, we can also expect the inputting ability of the new method should be remarkably improved.

Connected to this problem, Japanese Patent No.4968601 has proposed new method of inputting English, which allows to reflect English phonologic structure.

Main concept of this Patent is as follows; Firstly, preparing 2 virtual keyboards composed by software on one actual keyboard. One group of characters which is seen relatively frequent in English is set to the entry keyboard or basic keyboard. Remnant group of characters is set to the succeeding keyboard or secondary keyboard which is invoked by pressing down certain assigned key. Secondly, setting certain groups of characters, each group of which is composed of certain characters complimentary in spelling, all the characters in the group is inputted simultaneously by one stroke. The right spelling for this keystroke is decided automatically by consulting the dictionary provided to the portable input electronic apparatus.

This invention compiled the document of the US Constitution and other documents referring to it through Internet at random, to examine the frequency of the appearance of each letter in English.

Compiled frequency of the appearance of each letter in English is as follows; a(3400),b(710),c(1523),d(1529),e(5448),f(1044),g(707),h(22 16),i(3093),j (164),k(153),1(1882),m(1045),n(3371),o(3319), p(813),q(38),r(2737),s(2913),t(4049),u(1125),v(493),w(530) ,x(193),y(620),z(36).

As there is a big difference in the frequency of appearance of each letter in this compilation, from 5448 times for e and 36 times for z, inputting method of above-mentioned Patent to divide alphabet to 2 groups according to the frequency in appearance in English is reasonable.

Another problem is complementarity of the letter seen in the English word-spellling. The Patent considers there is full complementarity between two letters when certain letter in certain word is replaced by another letter, if new spelling does not exist in English. If new spelling exists in low extent in the same case, there is a weak complementarity.

The above Patent considers there is full complementarity among the characters c,k, and q. In this case, word spelling and keystroke-sequence correspond one-to-one. But there is only weak correspondence between the characters g and j. In this case, one keystroke-sequence corresponds plural word spellings and then it is needed to compile these results through certain software and display them on the screen to leave the choice to operator.

Above Patent shows one can input the same content with key touches little less than 130% of that of ordinary personal computer, using the keyboard with 9 keys arranged 3 keys by 3 keys.

### Prior Art

### Patent Reference

Japan Patent No.4968601
Japan Patent Pending No.2012-179947
Japan Patent Pending No.2012-184601
Japan Patent Pending No.2012-193544
Japan Patent Pending No.2012-196634

### Detailed Description of the Invention

Thus, the above-mentioned Patent is important as it made the operability of portable input electronic apparatus much higher than usual one and made it more similar to personal computer. But there remain some points to be argued and some points to be developed.

Firstly, word spelling and keystroke sequence do not correspond one-to-one in this method.

Secondly, as in this method one keystroke yields plural word spellings including many false one, it is needed to prepare new software to choose actual spellings.

Thirdly, as in this method an operator must choose a word among plural words displayed on the screen, there appears some difficulty in human interface.

Fourthly, as two switching keyboards are used in this method, there occurs some difficulty comparing to ordinary one keyboard personal computer.

Fifthly, though this method is specialized in English input, it is possible to enlarge the method to all European languages.

Core thesis of the present invention is to establish a new method which allows portable input electronic apparatus to input all the European languages with single keyboard arrangement beyond the limit of the above mentioned method specialized solely in English input.

As is mentioned before, the present invention shares the same opinion with above mentioned patent as to the nature of human interface of input method; certain inputting method is welcomed by clients when its human interface is excellent, and the basic need of human interface is to reflect deeply the phonetic structure of a given language.

Thus, the present invention is based upon the idea to formalize universal phonetic structure of European languages, or upon the idea and work to formalize general correspondency between phoneme and letter in all European languages.

The core purpose of the present invention is to develop the method of the above-mentioned patent in English input into the method available to all the European languages.

The present invention uses two kinds of method.

The first method is to succeed the idea of complementarity of letter in word spelling in English, and seek the way to apply this method to every European language.

The second method is to enlarge the idea of complementarity of letter in word spelling in English, and seek the way to establish the new method to be applied to every European language with the idea of similarity or resemblance of letter in word spelling.

As an expedient description relating to the previous patent, the first description is to be done about the invention utilizing the idea of similarity or resemblance of letter in word spelling in every European language, which is the first purpose of the present invention. And the second description is to be done about the invention utilizing the idea of complementarity of letter in word spelling in every European language, which is the second purpose of the present invention.

Let me explain the first phase of the invention. More specifically, the invention utilizing the idea of similarity or resemblance of letter in word spelling in every European language is divided into two categories.
The first one is to set plural letters, the pronunciation of which are similar or resemble each other in every European language, on the same key, and operator input the letters successively using 9 key keyboard, switched manually by operator. The key of this 9 key keyboard is arranged 3 by 3. The second one is to set plural letters, the pronunciation of which are similar or resemble each other in every European language, on the same key and operator input the letters successively using 15 key keyboard. The keys of this 15 key keyboard are arranged 3 by 5.

To realize this first invention, the invention to set plural letters on the same key throughout European language, for operator to input the letters successively using 9 key keyboard switched manually, it is needed to confirm that certain plural letters share some common phonetic nature throughout European languages

This invention, when it is realized, dissolves the problems of the preceding patent: discord between word spelling and keystroke, the need for new software, displaying of the input result on screen.

To realize this second invention, the invention to set plural letters on the same key throughout European languages using 15 key keyboard, it is needed to confirm that certain plural letters more than that of 9 key invention, share some common phonetic nature throughout European languages

This invention, when it is realized, dissolves the problems of the preceding patent caused by switching the keyboard manually.

Let me explain the second phase of the invention: more specifically, the invention utilizing the idea of complementarity of letter in word spelling in every European language.
This invention is to set plural letters that are complementary each other in word spelling in every European language on the same key. Operator inputs the letters simultaneously by one pressing down of the key and leaves the operation to identify the spelling to machine or to new software.
This invention is also divided into two categories. First one is using 9 key keyboard switched by operator. The keys are also arranged 3 by 3.

The second one is using 15 key fixed keyboard. The key of this keyboard is also arranged 3 by 5.

Here is a more detailed description on the concept of complementarity and phonetic resemblance or similarity of the letters in word spelling, and also the relationship between these two concepts.

Generally speaking, the phonetic structure of European languages is not clearly reflected in the letter system. So, here is given the explanation on the Japanese letter system or character system, which clearly reflects the Japanese phonetic structure, as a guidance to the issue.

Japanese syllabary called Fifty sounds table shows the Japanese phonetic structure consciously and definitely.

The syllabary maintains that the combination of one of 9 consonants with one of 5 vowels makes basic Japanese phoneme. In other words, the basic unit of Japanese phoneme is a combination of a consonant and a vowel.

For instance, the consonant s combined with a-line vowels a ,i,u,e,o, makes basic s-line characters, 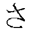 (sa), 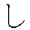 (si), 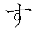 (su), 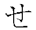 (se) 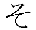 (so).

This is a general rule, but there are some exceptions. The consonant t combined with a-line vowels a, e, o, makes basic t-line characters, 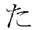 (ta), 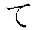 (te), 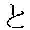 (to). But when the consonant t is combined with a-line vowels i,u, it does not make basic t-line character.
The combination of the consonant t with a-line vowels i, u, makes irregular characters 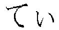 (ti), 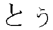 (tu).

Regular t-line consonant for vowel i is consonant ch, and the conbination of consonant ch and vowel i makes regular t-line character 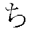 (chi), and the conbination of consonant ts and vowel u makes regular t-line character 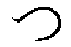 (tsu).

In this case, t-line characters in Japanese syllabary are composed of 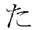 (ta), 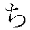 (chi), 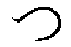 (tsu), 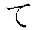 (te), 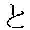 (to). In other words, the phoneme ti and tu are replaced by phoneme chi and tsu.

That is to say, in the conscious Japanese phoneme, t-line characters are composed of three consonants t,ch,ts, and 5 vowels a,i,u,e,o, and the complementarity among these three consonants t,ch,ts, in the combination with a-line vowels is perfect.

In other words, in Japanese inputting, the key assigned consonant t is in charge of t,ch,ts, at the same time, and because these three consonants have perfect complementarity in the union with 5 vowels, there is no problem at all in inputting so-called t-line characters.

Comprehensively, the complementarity in this case can be understood as a phenomena based on the roll allotment based on the commonness or similarity in the pronunciation.

In other words, we can affirm there is recognition of commonness or similarity in the pronunciation of the certain groups of letters in the notion of complementarity in the above-mentioned patent.

If the notion of complementarity in the above mentioned patent could be thus understood, it is possible, at least for 9 key keyboard in English to provide the same combination between keys and letters as the above mentioned patent, and set for operator to input each letter on the key successively according to the frequency of appearance of each letter in English. That is, the first press of the key yields the letter that appears most frequently in English and the second press for the second frequent letter, third for third, forth for forth.
Thus the first category of the first phase of present invention is achieved, because operator can input the letters, the pronunciation of which is similar or common, with one key. This peculiarity of the present invention to set the letters the pronunciation of which is is similar or common to the same key shall improve the human interface.

This procedure, setting a group of letters, the pronunciation of which is similar or common, to the same key and inputting these letters successively according to the frequency of appearance in given language, reflects the phonetic structure of given language and thus improves the human interface of inputting.

But there is one problem left unsettled in the prior patent. It laid stress on the finding of this complementarity in English and the notion of the comlementarity is not clearly defined. Here is given a brief explanation about the successive input method through 9 key keyboard arranged 3keys by 3keys, from the standpoint of the present invention.

In the case of English inputting, the standard for setting plural letters to the same key in the above-mentioned prior patent. was also the complementarity of letter in word spelling.

The patent maintains that this complementarity of letters is seen in 14 letters composing 5 groups: hiy, ckq, gj, sxz, uvw.

The present invention estimates the complementarity between h and iy is not so high, so only puts iy to the same key and sets h to another key, which is given by omitting the key taking charge of enlargement and reduction of letters in the prior patent.

Here is given a brief explanation as to the relation between the consonant letter and its phoneme in English, so far as the present invention concerns, sometimes adding the case of other languages according to the necessity, as a standard to understand the same relation in other European languages.

At first is given a brief table containing letters or a letters in word spelling, secondly, pronunciation of the letter in [], thirdly, position of the sound or phoneme and nature of the sound in().

m [m] (bilabial, nasal), p [p] b [b] (bilabial, occlusive), f [f] v [v] (labiodental, fricative), t [t] d [d] (alveolar, occlusive), s [s] z [z] (alveolar, fricative), ts [ts] ds [ds] (alveolar, affricate), sh [∫] s [3] in the case of pleasure (prepalatal, fricative), ch [t∫] in the case of church, j or dg [d3] in the case of judge(prepalatal, africate), ch [ç] in the case of German ich, y [j] in the case of you in English (palatal, fricative), k [k] g [g] (velar, occlusive), ch [x] in the case of German ach(velar, fricative), h [h] in English [glottal, aphonic]

In this grouping, relatively wide notion is used to include the entire phoneme in European languages, for example, a notion of dental-prepalatal is included in the notion of prepalatal , and the notion of explosive sound is included in occlusive sound.

In the above given parallel list, p [p], f [f], t [t], s [s], sh [∫], ch [t∫] in the case of church, ch [ç] in the case of German ich, k [k], ch [x] in the case of German ach, h [h] in English are aphonic and m [m], b [b], v [v] d [d], z [z] s [3] in the case of pleasure, j or dg [d3] in the case of judge, y [j] in the case of you in Engllish, g [g] are phonic.

Here we observe these 13 letters in 5 groups, iy,uvw, ckq, gj , sxz, from the standpoint of similarity or community of the phoneme each letter takes charge. I is vowel and y is semivowel, indicating essentially the same phoneme, there is a partial charge for them. There is a same sort of relation between u and vw. Also uw is bilabial sound and there is certain extent of affinity with the labiodental sound v. Letters c,k,and q share common phoneme [k], and there is a some extent of partial charge among them. Letters g and j also share common phoneme [d3] in some case.

In the case of English, the community or similarity of letters in the phoneme are typically seen in vowel and semivowel or letter c,k,and q, and seen to some extent in other letters. The input method utilizing this similarity and community among plural letters is reflecting the phonetic structure of English, so the method contributes to the improvement of human interface.

The prior patent, making use of two natures of the complementarity and commonness in the pronunciation and roll distribution based on this complementarity, is the most excellent inputting method from the standpoint of human interface. But it has also a weak point as it needs new software which requires large amount of work,

In the case of the first phase of the present invention, it only makes use of the one dimension of the complementarity, commonness or similarity in the pronunciation, to get predominance in the human interface over the traditional method almost common to all portable input electronic apparatus.

This successive inputting method of the present invention using 9key keyboard arranged 3keys by 3keys, sets 18 groups of letter or letters,a,e,h,iy,n,o,r,sxz,t,b,ckq,d,f,gj,l,m,p,uvw, to each of the 18 keys, just as same as the prior patent,

In the case of English inputting, the frequency of the appearance of the letter in each set of letters, is the same as this order, so if one press the key assigned for letters sxz, the first press yields s, the second press yields x, and the third press yields z, for example.

By the way, as is demonstrated below, it is basically possible to set the same letter or the same letters to each key in the case of each European language other than English, but the frequency of appearance of each letter or letters varies according to each language.

For example, as is explained before, the frequency of appearance of each letter of sxz corresponds to this order in English, but this order changes as szx in German, Italian, Spanish and Portuguese , and the order fo sxz remains only in French.

Thus, in the case of the present invention, letter or letters set to 9key keyboard arranged 3keys by 3keys are basically the same with prior patent. While these letters are inputted by one stroke there, the present invention inputs these letters successively.
This difference, theoretically speaking, influences the distribution of letter or letters to two keyboards; basic keyboard or entry keyboard and secondary keyboard or successive keyboard.

In the case of successive input, the first letter is inputted by only one stroke, but the second letter needs 2 strokes and the third letter needs 3 strokes, there is some difference compared to the method of the prior patent.

Here is given the formation of the English 9key keyboard for the successively input.of the present invention.

The letter a is set to row1 column1, e is set to row1 column2, iy is set to row1 column3, n is set to row2 column1, o is set to row2 column2, r is set to row2 column3, sxz is set to row3 column1, t is set to row3column2, uvw is set to row3 column3, in the basic keyboard or the entry keyboard.

The letter b is set to row1 column1, ckq is set to row1 column2, d is set to row1 column3, f is set to row2 column1, gj is set to row2 column2, h is set to row2 column3, l is set to row3 column1, m is set to the row3 column2, p is set row3 column3, in the secondary keyboard of successive method.

The difference between the keyboard of the prior patent and that of the present invention is an exchange of keyboard for the letters, specifically, basic keyboard for letter h, ckq and secondary keyboard for the letter sxz, r in the prior patent and the basic keyboard for letters sxz,r and the secondary keyboard for the letter h, ckq in the present invention. The reduction of keystroke brought forth by this improvement is not so big, but this change is significant from the standpoint of planning unified keyboard for every European languages.

Based upon the distribution of letters in the material refering to the Constitution of U.S.A., letter and letters set to each key and the sum of pressing down times for each key in the present invention is as follows. 9 groups for basic keyboard: a3400, e5448, (i3093, y620×2=1240, 4333 in total), n3371, o3319, r2737, (s2913, x193×2=386, z36×3=108, 3407 in total), t4049, (u1125, w530×2=1060, v493×3=1479, 3664 in total), and the grand total is 33728. 9 groups for secondary keyboard: b710, (c1523, k153×2=306, q38×3=114, 1943 in total), d1529, f1044, (g707, j164×2=328, 1035 in total), h2216, 11882, m1045, p813, and the grand total is 12217.
The final grand total of pressing down times for all of the letters is 58162, according to numerical formula: 33728+12217×2=58162.

When this material is inputted by ordinary personal computer, it only requires the simple total of the pressing down times for each letters 43151, according to the numerical formula: 33728+12217=43151. So the total pressing down times of keys of the present invention is approximately 135% of that of ordinary personal computer: according to numerical formula: 58162 ÷ 43151≒1.34787.

Next is the planning of 15key nonswitching keyboard for English input, which is one of the keyboards for European languages: the second category of the first phase of the present invention.

In this case, the same groupings of the letters, ckq, gj, iy, szx, uvw, assigned to each key is also available to this 15key keyboard method.

But keys given to input letters in switching 9key keyboard are 18, and those for nonswitching 15key keyboard are 15, so it is needed to omit 3 keys in this case.

Present invention sets another 3 groupings of the letters, mb, pf, gjh, for this purpose.

In the case of mb, [m] for m is phonic nasal sound in the mode of articulation and bilabial in the position of articulation, while [b] for b is phonic occlusive (explosive) sound in the mode of articulation and bilabial in the position of articulation. There is some extent of affinity in the nature of the phoneme.

In the case of pf, [p] for p is aphonic occlusive(explosive) sound in the mode of articulation and bilabial in the position of articulation, while [f] for f is aphonic fricative sound in the mode of articulation and labiodental in the position of articulation, there is some extent of affinity in the nature of the phoneme.

The prior patent already demonstrated the complementarity between g and j. As the present invention assumes there is a similarity of the phoneme between the letters as a basis for its complementarity, so the similarity of the phoneme among gj is a given fact. But it is perhaps needed to settle the problem from the standpoint of similarity again.

In the case of gj, g is phonic occlusive (explosive) sound in the mode of articulation and velar in the position of articulation when the phoneme is [g]. G is phonic fricative sound in the mode of articulation and alveolar in the position of articulation when the phoneme is [d3], while phoneme for j is generally [d3] agreeing with g. So phoneme [g] and phoneme [d3] also hold some extent of similarity ; both are phonic and the position and the mode of articulation of both phoneme are rather similar.

In the case of h, h is weak phonic fricative sound in the mode of articulation and glottal in the position of articulation. There is some extent of affinity with gj in the mode and the position of articulation, though not so clear.

Thus the formation of letter and letters to each key in 15key keyboard of the present invention is as follows: a, bm,ckq, d, e, fp, hgj, iy, l, n, o, r, sxz, t, uvw.

Based on the distribution of letters in the above mentioned Constitution of USA, total number of the times for pressing down keys to input the material in the present invention is as follows: a3400, (m1045, b710×2=1420, 2465 in total), (c1523, k153×2=306, q38×3=114, 1943 in total), d1529, e5448, (f1044, p813×2=1626, 2670 in total), (h2216, g707×2=1414, j164×3=492, 4122 in total), (i3093, y620×2=1240, 4333 in total), 11882, n3371, o3319, r2737, (s2913, x193×2=386, z36×3=108, 3407 in total), t4049, (u1125, w530×2=1060, v493×3=1479, 3664 in total), 48339 in grand total.

According to this result, the total number of the times for pressing down keys to input the Constitution of USA is 48339, when compared one by ordinary personal computer, the ratio is about 1.12, given by numerical formula: 48339÷43151≒1.1202.

The present invention examines German next, which has some affinity to English, and then examines Latin languages as Italian, French, Spanish and Portuguese, to plan the inputting method applicable to all European languages.

This successive method of inputting German in the present invention using 9key keyboard arranged 3keys by 3keys, sets 18 groups of letter or letters a, e, h, iy, n, o, r, sxz, t, b, ckq, d, f, gj, l, m, p, uvw, to each of 18 keys, as same as the case of English inputting.
But German uses 4 other letters ä, ö, ß, ü adding to English alphabet.

Then, plural letters set to each key are 19 in 7 groups: aä, ckq, gj, iy, oö, szßx, uvwü.

These vowels ä, ö, ß, ü, are called Umlaut, which is the result of vowel change influenced by the succeeding vowel. The present invention calls them changed vowel along with other accented vowels in Latin languages.

In the case of these changed vowels, their pronunciations are clearly related to the original vowels, so putting them to the same key, to which original vowels are set, yields good human interface. The present invention utilizes this relation and sets these changed vowels to the same key as original vowels.

There is also a similar phenomenon in European consonants: ss and ß in German, c and ç in French and Portuguese, n and ñ in Spanish. The present invention calls them changed consonants, and put them to the same key where the original consonant is set.

Thus, changed vowels and changed consonant in German are set to the same key where original vowels or consonant are set, as, a and o and ö, s and β, u and ü.

Here is given an expalnation on the affinity or similarity of pronuciation between plural letters set to the same key in German.

In the case of ckq, the pronunciation of letter c put in front of foreign words succeeded by a, o, u, as Café, Cola, Cup, is [k]. While the letter q always appears in the combination with letter u, and its pronunciation is [k]. The pronunciation of letter k is also [k].

In the case of gj, the pronunciation of g is almost always [g], but phonic prepalatal affricate sound [d3] appears in the case of Gin from English, and phonic prepalatal fricative sound [3] appears in the case of Girant, Girat, girieren from Italian. The pronunciation of j is almost always [j], but phonic prepalatal affricate sound [d3] appears in the case of Jazz, Jeep, Jet, from English, and phonic prepalatal fricative sound [3] appears in the case of Jongleur, jonglieren, Journal, journalistisch(→journaristique) from French.

Also, there is some similarity in the case of g as [g] and j as [j], as the former is phonic velar occlusive sound and the latter is phonic palatal fricative sound, both is phonic and the point of articulation is rather near.

In the case of iy, both hold the pronunciation [i], being vowel and semivowel corresponding each other.

In the case of sβxz, the pronunciation of letter s and leter β as a rule is aphonic alveolar fricative sound [s]. The pronunciation of letter s succeeded by vowels, is phonic alveolar fricative sound [z]. The pronunciation of letter x is [iks] or [ks], and the phoneme [s] is common with the letter s.

The letter x is primarily used in the very few Greek origin words and scholarly words.

While the pronunciation of letter z is as a rule phonic alveolar affricate sound [ts], excepting Gaze [z], Bronze [s], but is also phonic alveolar fricative sound [z] in some words from English, as Zero, Zoom. The phoneme [ts] for letter z is alveolar affricate sound and this point of articulation is the same with that of [s] and [z] and the mode of articulation is also near to that of [s] and [z].

In the case of uwvü, ü is a changed vowel of u, and the phoneme of letter u is [u] and that of w is [v], so there is also a kind of vowel and semivowel relation between letter u and letter w.

The pronunciation of letters uüw is phonic rounded sound and that of letter v is labiodental phonic sound. The point of articulation is near and letters v and w are both succeeded by vowel in the word spelling, which suggests the letter v has something near to semivowel.

The pronunciation of letter v is usually [f], and sometimes it takes the phoneme [v], the general phoneme for the letter w.

Thus we can anticipate English plan or formation in inputting is also available to that of German, in the case of using switching 9key keyboard. But it is necessary to examine concretely whether the English formation can be applied to the German keyboard.

We shall examine the frequency of letters appeared in the German Constitution "Grundgesets für die Bundesrepublik Deutschland" promulgated in 1949.

The letters seen in this Constitution are as follows: a6618, b3617, c3133, d8951, e24050, f2393, g5668, h5120, i9098, j150, k1419, 14367, m2789, n14250, o2252, p491, q5, r10165, s9456, t8251, u6417, v1418, w1520, x10, y12, z2170, β365, ä1045, ö419, ü744. The letters in total are 136363.

When we input this Constitution with the 9key keyboard of the present invention, in the case one letter is assigned to one key, the letter is inputted by one pressing down of the key. But, in the case of aä, gj, iy, oö, two letters are assigned to one key, the second letter is inputted by pressing down twice. In the case of ckq, three letters are assigned to one key, the second letter is inputted by pressing down twice and the third letter is inputted by pressing down thrice. In the case of szßx snd uwvü, four letters are assigned to one key, the second letter is inputted by pressing down twice and the third letter is inputted by pressing down thrice , the fourth letter is inputted by pressing down four times.

According to this rule, the frequency of pressing down of each key are as follows.

The order of the key taking charge of inputting letter or letters is decided by alphabetic order of the first letter of the key.

(a6618, ä1045×2=2090, 8708 in total), b3617, (c3133, k1419×2=2838, q5×3=15, 5986 in total), d8951, e24050, f2393, (g5668, j150×2=300, 5968 in total), h5120, (i9098, y12×2=24, 9122 in total), 14367, m2789, n14250, (o2252, ö419×2=838, 3090 in total), p491, r10165, (s9456, z2170×2=4340, ß365×3=1095, x10x4=40, 14931 in total), t8251, (u6417, w1520×2=3040, v1418×3=4254, ü744×4=2976, 16687 in total).

When these keys are arranged to the order of the frequency of pressing down, the new order is as follws: e24050, uwvü16687, szßx14931, n14250, r10165, iy9122, d8951, aä8707, t8251, ckq5986, gj5968, h5120, 14367, b3617, oö3090, m2789, f2393, p491.

As this method distributes letter and group of letters into two keyboards, it is advantageous to set the first half 9 keys to the basic keyboard or entry keyboard, and the second half 9 keys to the secondary keyboard or succeeding keyboard.

According to this rule, keys for e(24050), uwvü(16687), szßx(149319, n(14250), r(10165), iy(9122), d(8951), aä(8707), and t(8251), are put to the basic keyboard or entry keyboard, while keys for ckq(5986), gj(5968), h(5120), l(4367), b(3617), oö(3090), m(2789), f(2393) and p(491) are put to the secodary keyboard or succeeding keyboard.

According to this formation, the total numbers of pressing down of the keys in the basic keyboard are 115115, and the total numbers of pressing down of the keys in the secondary keyboard are 33821. In the actual process of inputting, one more pressing down or one more stroke is needed to enter the secondary keyboard, so the grand total times are 182757, according to numerical formula: 115115+33821×2=182757.

In the case of ordinary personal computer, the total numbers of pressing down of the keys are equal to the numbers of all the letters in the material: German Constitution. So, ratio of the total numbers of pressing down of the keys of the present invention compared to ordinary personal computer is about 134%, according to numerical formula: 182757÷136363=1.3402.

But in this formation, the key for letters oö, and the key for letter t are set to the secondary keyboard, and the key for letter d and the key for letters ckq are set to the basic keyboard. As this formation is contradictory to general tendency of other European languages, the present invention maintains to set the key for letters oö and the key for letter t to the basic keyboard, setting the key for letter d and the key for the letter ckq to the secondary.

In this universal formation, the keys for, e(24050), uwvü(16687), szßx(149319, n(14250), r(10165), iy(9122), aä(8707), t (8251) and oö(3090), are set to the basic keyboard, the keys for d(8951), ckq (5986), gj(5968), h(5120), 1(4367), b(3617), m(2789), f(2393) and p(491) are set to the secondary keyboard.

According to this formation, the total numbers of pressing down of the keys in the basic keyboard are 109253, and the total numbers of pressing down of the keys in the secondary keyboard are 39682. In the actual process of inputting, one more pressing down or one more stroke is needed to enter the secondary keyboard, so the grand total numbers are 188617, according to numerical formula: 109253+39682×2=188617.

In the case of ordinary personal computer, the total numbers of pressing down of the keys are equal to the numbers of all the letters in the material: the German Constitution. So, the ratio of the total numbers of pressing down of the keys of the present invention compared to ordinary personal computer is about 138% according to the numerical formula: 188617÷136363=1.3832.

This is a plan for successive German input, using switching keyboard arranged 3 keys by 3 keys. It is important that in the case of German input, there is the same affinity or similarity as seen in English, in the groups of letters: iy, ckq, sxz, gj, uwv. This phenomenon suggests that the relation between letter and phoneme in English has some universality, namely the same relation might be widely seen in European languages.

Another important fact is there are some groups of letters, the phoneme of which resemble each other throughout European languages.

The present invention makes use of this resemblance of phonemes among European letters in order to plan 15key keyboard for European languages.

German keyboard of the present invention utilizes similarity or partial similarity of the phoneme of letters, seen in the groups of letters, iy, ckq, gj, uwvü, sßxz, aä and oö. And it also utilizes the resemblance of phoneme of letters as well to plan the successive input method of 15keyboard arranged 3 by 5.

The groups utilized in German are mb, fp, ghj, all the same with English.

In the case of mb, [m] for m is phonic nasal sound in the mode of articulation and bilabial in the position of articulation, while [b] for b is phonic occlusive (explosive) sound in the mode of articulation and bilabial in the position of articulation, so there is some extent of affinity in the nature of the phoneme.

In the case of pf, [p] for p is aphonic occlusive(explosive) sound in the mode of articulation and bilabial in the position of articulation, while [f] for f is aphonic fricative sound in the mode of articulation and labio-dental in the position of articulation, so there is some extent of affinity in the nature of the phoneme.

The prior Patent already demonstrated the complementarity between g and j. As the present invention assumes there is a similarity of phoneme between the letters as a basis for its complementarity, so the similarity of phoneme between gj is a given fact. But it is perhaps needed to settle the problem from the standpoint of similarity again.

As is mentioned before, in the case of German, the pronunciation of g is almost always [g], but phonic prepalatal affricate sound [d3] appears in the case of Gin from English, and phonic prepalatal fricative sound [3] appears in the case of Girant, Girat, girieren from Italian. The pronunciation of j is almost always [j], but phonic prepalatal affricate sound [d3] appears in the case of Jazz, Jeep and Jet from English, and phonic prepalatal fricative sound [3] appears in the case of Jongleur, jonglieren, Journal, Journalistisch(←jouranalistique) from French.
Also, there is some similarity in the case of g as [g] and j as [j], as the former is phonic velar occlusive sound and the latter is phonic palatal fricative sound, both are phonic and the point of articulation is rather near.

The phoneme of j is almost always [j], which is phonic palatal fricative sound. The point of articulation for both [g] and [j] is near.

In the case of h, h is weak aphonic fricative sound in the mode of articulation and glottal in the position of articulation, so there is some extent of affinity with gj in the mode and the position of articulation, though not so clear.

Thus the formation of letter and letters to each key in 15key keyboard for German of the present invention is as follows: aä, bm, ckq, d, e, fp, hgj, iy, l, n, oö, r, szßx, t, uüvw.

Based on the distribution of letters in the above mentioned Constitution of Germany ,each number and total numbers needed for pressing down keys to input the material are as follows: (a6618, ä1045×2=2090, 8708 in total),(b3617, m2789×2=5578, 9195 in total), d8915, e24050, (f2393, p491×2=982, 3375 in total), (g5668, h5120×2=10240, j150×3=450, 16358 in total), r10165, (s9456, z2170×2=4340, ß365×3=1095, x10×4=40, 14931 in total), t8251, (u6417, w1520×2=3040, v1418×3=4254, ü744×4=2976, 16687 in total). Grand total is 157486.

According to this result, the total numbers for pressing down keys to input the Constitution of Germany is 157486, and compared with ordinary personal computer, the ratio is about 116%, given by the numerical formula: 157486÷136363≒1.1549.

The followings are plannings of the keyboard for Latin languages. Italian is the first to be examined.

In the case of successive input in Italian through 9key keyboard, all is the same as that of English and German, so two plans are needed. The plan for the layout of letters in each key and that for each keyboard, which is manually switched.
The first letter is input only by one stroke, but the second letter needs 2 strokes and the third letter needs 3 strokes, so the frequency of appearance of the first letter in Italian should be the highest, second for second and third for third. Also, the keys for the letter or letters with high frequency in appearance in Italian, should be put to the basic keyboard and the rest should be put to the secondary keyboard, which needs another stroke of the key in charge to be invoked.

As for the plan of the layout of letters in each key it can be used the same plan for English and German, both in the case of 9key keyboard and 15key keyboard.

We shall examine the frequency of each letter appeared in the current Italian Constitution revised in 2003.

The letters seen in this Constitution are as follows: a8598, b914, c3265, d3602, e11161, f683, g2380, h335, i11197, j0, k0, 16831, m2089, n6434, o7996, p2295, q218, r5620, s4233, t6376, u2442, v1120, w0, x19, y0, z1267, à210, è133, é25, ì32, î1, ò87, ù12, ü2. The total number is 89577.

This successive method of inputting Italian in the present invention using 9key keyboard arranged 3keys by 3keys, sets 9 groups of letter or letters to the basic leyboard : a and changed vowel à, e and changed vowel è, é, iy and changed vowel ìî, n, o and changed vowel ò, r, sxz, t, uvw and changed vowel ùü.

Other 9 groups of letter or letters are set to the secondary keyboard: b, cqk, d, f, gj, h, l, m, p.

The frequency of the appearance of each letter or letters set to each key in the Italian Constitution and the grand total of these figures are as follows.

Basic keyboard: (a8598, à210×2=420, 9018 in total), (e11161, è133×2=266, é25×3=75, 11502 in total), ( i11196, ì32×2=64, î1×3=3 y0, 11264 in total), n6434, (o7996, ó87×2=174, 8170 in total), r5620, (s4233, z1267×2=2534, x19×3=57, 6824 in total), t6376,(u2442, v1120×2=2240, ù12×3=36, ü2×4=8, w0, 4726 in total). The grand total is 69934. Secondary keyboard: b914, (c3265, q218×2=436, k0, 3701 in total), d3602, f683, (g2380, j0, 2380 in total), h335, 16831, m2089, p2295. The grand total is 22830.

In the case of the above mentioned Italian keyboard with 9keys arranged 3keys by 3 keys, the current Italian Constitution is input by the total strokes of the basic keyboard and doubled total strokes of the secondary keyboard. The grand total is 11558 times given by numerical formula: 69928+22830×2=115588.

In the case of inputting the Constitution by ordinary personal computer, the total strokes are given by the sum of the letters : a8598, b914, c3265, d3602, e11161, f683, g2380, h335, i11197, j0, k0, 16831, m2089, n6434, o7996, p2295, q218, r5620, s4233, t6376, u2442, v1120, w0, x19, y0, z1267, à210, è133, é25, ì32, î1, ò87, ù12, ü2. That is 89577.

According to this result, the total numbers of the keystrokes for the letters to input the Italian Constitution is 115588, and compared with ordinary personal computer, the ratio is about 129%, given by numerical formula: 115588÷89577≒1.2904.

This invention is realized when it is certified that there is phonetic commonness or affinity among the Italian letters put to the same key.

In the case of a and à.e, è, and é.i, ì and î,o and ò.u, ù, and u, there is similarity or affinity seen between vowel and changed vowel.

There is also similarity or affinity seen between vowel and semi-vowel in the case of letter i and letter y, letter u and letter v..

In the case of u and v, it is hard to maintain there is a vowel-semivowel relation. But there is a kind of affinity in the position of articulation because u is a bilabial sound and v is a labio-dental sound.

Furthermore, according to an Italian dictionary, letters j, k, w, and y do not exist in original Italian alphabet and they are exclusively given for the notation of foreign words. As the frequency of their appearance is very low, it is possible to neglect them in practical use.

Also, the letter x is given for the notation of Greek origin words and some other foreign words. And the frequency of the appearance is also low.

Keeping the peculiarities of the letter j, k, w, y and x in mind, here is given an explanation as to the similarity or affinity between the letter c and the letter q, accompanyng the case of the letter k with them, the letter g and the letter j, the letter s and the letter z, accompanyng the case of the letter x with them.

In the case of the letter c, k, and q, the phoneme of the letter c is [k], followed by vowel o, a, u, as in the cases of cabina, coda, cuoco. While the letter k is not seen in the Italian Constitution, the phoneme for it is [k]. The letter q is always combined with the letter u and the phoneme for q is [k].

The phoneme of c is [t∫], when followed by vowels i,e, as in the case of cina or pace. The combined letter ch as in the case of chilo, is pronounced as [k] . Thus at least the letters ckq are pronounced [k] in many cases.

In the case of letters g and j, the phoneme of the letter g is [g], when followed by vowels
o,a,u, as in the cases of gatto, albergo, guasto, and is [d3] when followed by vowels e
or i as in the cases of gelato, originale, Giappone.

The letter j does not exist in original Italian alphabet, and is not seen in the Italian Constitution. The phoneme for it is [d3]
in the case of judo and is [j] in the case of Jubentus. [d3] and [j] are both phonic
affricative sounds. [g] is phonic velar in the position of articulation, near to that of [d s] and [j].

In the case of letter s and letter z, phoneme of letter s is usually [s], and [z] when
followed by phonic consonant.

Letter z is usually pronounced [ds] or [ts], these phoneme are both alveolar affricate sound. The position of articulation is the same as that of [z] and [s].

The phoneme of z is [z], in the case of garzo and manzo, which is similar with that of s in some cases.

Letter x is mainly used for the notation of foreign word and the frequency of appearance is low. Its phoneme is [ks] usually and [z] in the case of place-name Xauza. The phoneme [ks] contains [s] and [z] is phonic sound of [s].

Above mentioned explanation certifies that there is phonetic commonness or affinity among the Italian letters put to the same key in the 9key keyboard arranged 3keys by 3keys.

Above mentioned is an explanation of successive input using 9key keyboard, arranged 3keys by 3keys, in the present invention.

Hereafter is shown an explanation of 15key keyboard successively input.

Above mentioned 9 key keyboard uses 18 keys according to numerical formula; 3×3×2=18. But only 15 keys can be used for this 15key keyboard successively inputted according to numerical formula: 3×5=15.

The letter or letters set to each of 15 keys is basically the same with the case of English: a and its changed vowel à, mb, cqçk, d, e and its changed vowels èé, pf, ghj, i and its changed vowels i, i and y, l, n, o and its changed vowel o, r, sxz, t, u and its changed vowel ùü and vw.

There are combinations of mb, pf and ghj, as utilized in the case of English input and German input.

In the case of mb in Italian, [m] for m is phonic nasal sound in the mode of articulation and bilabial in the position of articulation, while [b] for b is phonic occlusive(explosive) sound in the mode of articulation and bilabial in the position of articulation, so there is some extent of affinity in the nature of the phoneme.

In the case of pf, [p] for p is aphonic occlusive(explosive) sound in the mode of articulation and bilabial in the position of articulation, while [f] for f is aphonic fricative sound in the mode of articulation and labio-dental in the position of articulation, so there is some extent of affinity in the nature of the phoneme.

In the case of gj, when the phoneme is [g]. G is phonic occlusive(explosive) sound in the mode of articulation and velar in the position of articulation, and is phonic affricative sound in the mode of articulation and prepalatal in the position of articulation when the phoneme is [d3]. The letter j does not exist in original Italian alphabet and is not seen in the current Italian Constitution. In the notation of foreign words, the phoneme for j is generally [d3] or [j]. The phoneme [g] and phoneme [d3] also hold some extent of similarity ; both are phonic and the position and the mode of articulation of both phoneme are rather similar.

In the case of h, [h] is weak phonic fricative sound in the mode of articulation and glottal in the position of articulation, so there is some extent of affinity with gj in the mode and the position of articulation, though not so clear. Referring to other languages, the phoneme [h] between two vowels frequently disappears in Japanese(ihite→iite), phoneme [g] between two vowels frequently disappears in Mongolian(bagator→baator). There is some extent of affinity in the phoneme whose point of articulation is velar or glottal.

The frequency of appearance of each letter or each group of letters in the Italian Constitution and the corresponding key stroke in the present invention with the formation of 15key keyboard arranged 3 by 5 are as follows.

(a8598,à×2=420, 9018 in total),(m2089,b914×2=1828, 3917 in total), (c3265, q218×2=436, k0, 3701 in total), d3602, (e11161, è133×2=266, é25×3=75, 11502 in total),(p2295, f683×2=1366, 3661 in total), (g2380, h335×2=670, j0, 3050 in total), (i11196, i32×2=64, î1×3=3, y0, 11264 in total), 116831, n6434, (o7996, ò87×2=174, 8170 in total), r5620, (s4233,z1267×2, z1267×2=2534, x19×3=57, 6824 in total), t6376, (u2442, v1120×2=2240, ù12×3=36, ü2×4=8, w0, 4720 in total).

As Italian 15 keyboard is not switched, the grand total amount of the strokes of each key is equal to the sum of the strokes needed to input Italian Constitution.

They are 94696, according to numerical formula: 9018+3917+3701+3602+11502+3661+3050+11264+6831+6434+8170+5 620+6824+6376+4726=94696.

As is affirmed before, the total strokes of personal computer to input the Italian Constitution are 89577, so the ratio of strokes of the present invention to personal computer is 1.0571, according to numerical formula: 9469 ÷ 89577 ≒ 1.0571. That is, the present method is able to input the same contents by about 106% of the strokes in case of using personal computer.

The following is an examination of French input selected as the second Latin language.

In this case, either 9key method or 15key method, is able to adopt the same method as English one in the plan for grouping characters.

In the case of succesive input through 9key keyboard in French, all the same with that of English, the first letter is input only by one stroke, but the second letter needs two strokes and the third letter needs three strokes, so the frequency of apperance of the first letter in French should be the highest, the second for the second and the third for the third. Also, keys containing the letter or letters with high frequency in appearance in French should be put to the basic keyboard and the rest should be put to the secondary keyboard, which needs another one stroke of the key to be invoked.

We shall examine the frequency of each letter appeared in the 1958 French Constitution

The letters seen in this Constitution are as follows: a6484, b953,d5009, e14444, f815, g987, h221, i8838, j317, k0, 16356, m2716, n8079, o6729, p3297, q745, r7084, s8757, t7932, u5345, v1243, w1, x577, y71, z13, à353, â6, é3469, é275, ê143, î1, ô60, ù4, 105063 in total.

This succesive method of inputing French in the present invention using 9key keyboard arranged 3keys by 3keys, sets 9 groups of letter or letters to the basic keyboard such as in the English method: a and its changed vowels, e and its chaged vowels, i and its changed vowels and y, n, o and its chaged vowels, r, szx, t, u and its changed vowels and vw.

Other 9 groups of letter or letters are set to the secondary keyboard: b, cqçk, d, f, gj, h, l, m, p.

The frequency of appearance of each letter or letters set to each key in the French Constitution and the grand total of these figures are as follows.

Basic keyboard:(a6484, à353×2=706, â6×3=18, 7208 in total), (e14444, é3469×2=6938, è275×3=825, 22779 in total), (i8838, y71×2=142, î×3=3, 8983 in total), n8079, (06729, ô60×2=120, 6849 in total ), r7084, (s8757, x577×2=1154, z13×3=39, 9950 in total), t7932, (u5345, v1243×2=2486, ù4×3=12, w1×4=4, 7847 in total). The grand total is 86711. Secondary keyboard: b (953), (c3711, q745×2=1490, ç28×3=84, k0, 5285 in total ), d(5009), f(815), (g987, j317×2=634, 1621 in total), h(221), 1(6356), m(2716), p(3297), The grand total is 26273.

In the case of above mentioned French keyboard with 9keys arranged 3keys by 3keys, the current French Constitution is inputted by the total strokes of the basic keyboard and doubled total strokes of the secondary keyboard. That is 139257 times given by numerical formula: 86771+26273×2=139257.

In the case of inputing the Constitution by ordinary computer, total strokes are given by the sum of figures for each letter: a6484, b953, c3711, d5009, e14444, f815, g987, h221, i8838, j317, k0, 16356, m2716, n8079, o6729, p3297, q745, r7084, s8757, t7932, u5345, v1243, w1, x577, y71, z13, à353, â6, é3469, è275, ê143, î1, ô60, ù4. That is 105063.

The total number of keystrokes for the letters to input the Constitution of France in the present invention is 139257, when compared with the grand total by ordinary personal computer, the ratio is about 133% given by numerical formula: 139257÷105063≒1.3255.

This invention is realized when it is certified that there is phonetic commonness or affinity among the French letters put to the same key.

In the case of a, â and à, e, e, e and e, i and î, o and ô, u and u, there is similarity or affinity between the vowel and its changed vowel.

There is also similarity or affinity beteen vowel and semi-vowel in the case of i and y, u and v.

In the case of u and v, it is difficult to maintain there is a genuine relation between vowel and semi-vowel, but there is a kind of affinity in the position of articulation because u is a bilabial sound and v is labio-dental sound.

According to a French dictionary, the letter k and the letter w do not exist in the original French alphabet and exclusively given for the notation of foreign words. Also, the letter z and the letter y are usually given for the notation of foreign words. As the frequency of their apperance is also very low, it is possible to neglect them in practical use.

The letter x in the beginning of a word is usually used in the notation of foreign words.
When used in the middle or ending of a word, it often takes the silent form as beaux in
the inflection of word beau or bell. It does not positively conflict with the pronunciation of the letter s nor the letter z in this case.

Here is given an explanation as to the similarity or affinity between the letter c and the letter q, accompanying the case of rare letter k with them, letter g and letter j, letter s and letter z, accompanying the case of rare letter x with them, taking their rareness into consideration.

In th case of letter c, k, and q, the phoneme of letter c is [k], followed by vowel a, o, u, as in the case of café, code, cuve. The letter k does not exist in the original French alphabet, also is not seen in the French Constitution just examined, and its pronunciation is [k] . The letter q is always combined with the letter u and the phoneme of the letter q is [k].

The phoneme of the letter c is [s], when followed by vowel i or vowel e,as in the case of ci, ce, but , in other cases, the letter c, q, k, share the phoneme [k] .

In the case of the letters g and j, the phoneme of the letter g is [g], when followed by vowels a, o, ui, ue, or consonant, as in the case of gage, gomme, guet, guide, glace, and is [3] in the case of gens, gibier.

The phoneme for the letter j is always [3]. So the coincidence of the phoneme of the letter g and letter j is partial. But the phoneme [3] is a phonic prepalatal fricative sound and the phoneme [g] is a phonic velar occlusive sound. Therefore the point of articulation and the mode of articulation is near each other.

In th case of the letter s and the letter z, the phoneme of the letter s is usually [s] as in the case of son, but sometimes is [z] as in the case of maison.

The letter z is usually pronounced [z]. It is a phonic alveolar fricative sound. The phoneme [s] is an aphonic alveolar fricative sound. The point and the mode of articulation are the same.

The letter x is mainly used for the notation of foreign words and it seldom appears in the beginning of a word. The phoneme for it is [ks], containing phoneme [s]. It is not pronounced when it is located in the middle or at the end of a word, so it does not positively conflict with the current method.

With above mentioned explanation it is certified that there is phonetic commonness or affinity among the French letters put to the same key in the case of 9key keyboard arranged 3keys by 3keys.

Above mentioned is an expalnation of succesive input method with 9key keyboard arranged 3keys by 3keys in the present invention.

Hereafter is an explanation of 15key keyboard also for succesive input.

18 keys are used in the above mentioned invention according to numerical formula; 3×3×2=18, but only 15 keys can be used for this 15key keyboard succesive input method according to numerical formula; 3×5=15.

The letter or letters set to each of 15 keys is basically the same with that of English: a , and its changed vowels à and â, mb, cqçk, d, e and its changed vowels e, e and e, pf, gjh, i and its changed vowel i and y, 1, n, o and its changed vowel ô, r, sxz, t, u and its changed vowels u and vw.

The combinations of mb, pf, and ghj are newly added to the 9key method of the present invention. This method is already utilyzed in the case of English input.

In the case of mb in French, [b] for b is a phonic occlusive(explosive) sound in the mode of articulation and bilabial in the position of articulation, while [m] for m is a phonic nasal sound in the mode of articulation and bilabial in the position of articulation.

In the cace of fp in French, [f] for f is an aphonic fricative sound in the mode of articulation and labio-dental in the position of articulation, while [p] for p is an aphonic occlusive(explosive) sound in the mode of articulation, so there is some extent of affinity in the nature of the phoneme.

In the case of gj in French, g is a phonic occlusive (explosive) sound in the mode of articulation and velar in the position of articulation when the phoneme is [g], and is phonic fricative in the mode of articultion and prepalatal in the position of articulation when the phoneme is [3]. In the case of j, its phoneme [3] is phonic fricative in the mode of articultion and prepalatal in the position of articulation. H is originally supposed to be an aphonic glottal weak fricative sound and is not pronounced nowadays.

The commonness or affinity among gj and h is not so clear but there is some extent of commonness or affinity between the phonemes of them. Refering to other languages, the phoneme [h] between two vowels frequently disappears in Japanese(as seen in the cace: ihite→iite), and the phoneme [g] bewteen two vowels frequently disappears in Mongolian (as seen in the case: bagator→baator). There is commonness or affinity in the articulation point which is situated at velar or the more inner part of the oral cavity.

The frequency of appearance of each letter or each group of letters in the French Constitution and the corresponding key strokes in the present invention with the formation of 15key keyboard arranged 3 by 5 are as follows.

(a6484, à353×2=706, â6×3=18 ,7208 in total),(m2716, b953×2=1906, 4622 in total),(c3711,q745×2=1490, ç28×3=84, k0,5285 in total), d5009, (e14444, é3469×2=6938, è275×3=825, ê143×4=572, 22779 in total), (p3297, f815×2=1630, 4927 in total), (g987, j317×2=634, h221×3=663, 2284 in total),(i8838, y71×2=142, î1×3=3, 8983 in total), 16356, n8079, (o6729, ô60×2=120, 6849 in total), r7084, (s8757, ,x577×2=1154, z13×3=39, 9950 in total), t7932, (u5345, v1243×2=2486, ù4×3=12,w1x4=4, 7847 in total).

As French 15 keyboard is not switched, the total amount of the strokes of each key is equal to the sum of the strokes needed to input the French Constitution.

The total amount is 115194, according to numerical formula: 7208+5285+5009+22779+4622+4927+2284+8983+6356+8079+6849+70 84+9950+7932+7847=115194.

As affirmed before, the total strokes of personal computer to input the French Constitution is 105063. So, the ratio of strokes of the present invention to the total strokes of personal computer is 1.0964, according to numerical formula: 115194÷105063≒1.0964. That is, the present method is able to input the same contents by about 110% of the strokes needed in case of personal computer.

The following is an examination of Spanish input method selected as the third Latin language.

In this case, either 9key method or 15key method, is able to adopt the same method as English one in the plan for grouping characters..

In the case of succesive input through 9key keyboard in Spanish, all the same with that of English; the first letter is input only by one stroke, but the second letter needs two strokes and the third letter needs three strokes, so the frequency of apperance of the first letter in Spanish should be the highest, the second for the second and the third for the third. Also, keys containing the letter or letters with high frequency in appearance in Spanish should be put to the basic keyboard and the rest should be put to the secondary keyboard, which needs another one stroke of the key to be invoked.

We shall examine the frequency of each letter appeared in the 1978 Spanish Constitution.

The letters seen in this Constitution are as follows: a9550, b992, c4809, d5153, e11358, f593, g1021, h267, i6592, j318, k0, 15622, m2114, n6104, ñ100, o7947, p2501, q358, r6347, s7306, t4436, u3104, v605, w0, x117, y1037, z243, à747, é170, i543, ó812, ú135.

This succesive method of inputing Spanish in the present invention using 9key keyboard arranged 3keys by 3keys, sets 9 groups of letter or letters to the basic keyboard as in the English method: a and its changed vowel, e and its changed vowel, i and its changed vowel and y, n, o and its chaged vowel, r, szx, t, u and its changed vowel and vw.

Other 9 groups of letter or letters are set to the secondary keyboard: b, cqk, d, f, gj, h, l, m, p.

The frequency of appearance of each letter or letters set to each key in the present invention to input Spanish Constitution and the grand total of these figures are as follows.

Basic keyboard: (a9550, á744×2=1488, 11038 in total), (e11358, é170×2=340, 11698 in total), (i6592, y1037×2=2074, í543×3=1629, 10295 in total), (n6104, ñ×2=200, 6304 in total), (07947, ó812×2=1624, 9571 in total), r6347, (s7306, z243×2=486, x117×3=351, 8143 in total), t4436, (u3104, v605×2=1210, ú135×3=405, w0, 4719 in total), Grand total is 72555. Secondary keyboard: b992, (c4809, q358×2=716, k0, 5525 in total), d5153, f593, (g1021, j318×2=636, 1657 in total), h267, 15622, m2114, p2501, Grand total is 24424.

In the case of the above mentioned Spanish keyboard with 9key arranged 3 by 3, the current Spanish Constitution is inputted by the total strokes of the basic keyboard and doubled total strokes of the secondary keyboard. That is 121399 times given by numerical formula: 72551+24424×2=121399.

In the case of inputing the Constitution by ordinary computer, total strokes are given by the sum of figures for each letter: a9550, b992, c4809, d5153, e11358, f593, g1021, h267, i6592, j318, k0, 15622, m2114, n6104, o7947, p2501, q358, r6347, s7306, t4436, u3104, v605, w0, x117, y1037, z243, á744, é170, í543, ó812, ú135, 90998 in total.

According to this result, the total number of keystrokes for the letters to input the Constitution of Spain is 121399. When compared to the sum by ordinary personal computer, the ratio is about 133% given by numerical formula: 121399÷90998≒1.3341.

As is seen above, in the case of 9key keyboard arranged 3keys by 3keys for Spanish input of the present invention, the keyboard formation is quite the same as English and French one. If it is to be composed utterly corresponding to Spanish phonological method, the key for t(4436) and the key for uvúw (4719) (u3104,v605, ú135, w0) in the basic keyboard are to be exchnaged with the key for cqk(5525)(c4809, q716, k0) and the key for d(5153) in the secondary keyboard..

The method of the present Spanish keyboard concedes to Englsh, Italian, French method in this point. But the extent of consession is about 1.7%, according to the following numerical formula: (5525+5153-4719-4436)÷90998≒0.01674.

This invention is realized when it is certified that there is phonetic commonness or affinity among the Spanish letters put to the same key.

In the case of a and à, e and e, i and i, o and ó, u and u, there is a similarity or affinity seen between vowel and its changed vowel.

There is also similarlity or affinity between vowel and semi-vowel in the case of i and y. The frequency of the appearance of y in Spanish is also low.

The phoneme used for the appelation of letter v is [úbe] and one for letter w is [úbedóble], which sugggests there is a kind of affinity between them. Vowel u corresponds with this semi-vowel. Also the letter w is used for the notation of foreign words and is seldom used. It is not seen in the current Spanish Constitution.

Though it is rather difficult to maintain the letter v is genuine semi-vowel, there is a kind of affinity in the position of articulation because u is a bilabial sound and v is a labio-dental sound.

The letter k is exclusively given for the notation of foreign words and seldom appears in Spanish.

Also, the letter x is mainly given for the notation for Greek origin words and other foreign words and seldom appears in Spanish..

Here is given an explanation as to the similarlity or affinity between the letter c and the letter q, accompanying the case of the rare letter k with them, the letter g and the letter j, the letter s and the letter x, accompanying the case of the rare letter z with them, taking their rareness given above into consideration.

In th case of letters c, k, and q, the phoneme of letter c is [k] when followed by vowel a, o, u, as in the case of casa, coche, curso. And its phoneme is [s] or [θ] when followed by vowel e, i, as in the case of centro, cine.

The letter k is rarely seen in Spanish and does not appear in the current Constitution, but its phoneme is [k]. The letter q is always combined with the letter u and the phoneme of the letter q itself is [k].

Thus it is clear that Spanish letters c, k and q share the common phoneme [k].

In the case of letters g and j, the phoneme of letter g is [g] when followed by vowels a, o, u, as in the case of gato, goma, gusto, and is [x] as in the case with general, girasol. The phoneme for the letter j is usually [x], and it' s a fricative velar sound. There is some extent of coincidence between the phoneme of letter g and the phoneme of letter j.

In th case of the letter s and the letter z, the phoneme of the letter s is usually [s], but when it is followed by phonic consonant it is near to [z] as in the case of mismo.

The letter z is usually pronounced [3], but it is [s] in Latin America, North America and some area of the Iberian Penisula.

The letter x is mainly used for the notation of foreign words and it seldom appears in Spanish. Its phoneme is [ks], containing phoneme [s], and is also [s] when it is located at the beginning of a word or placed before connsonant as in the case of texto. There is some extent of coincidence between the phoneme of the letter x and the phoneme of the letter s.

With the above mentioned explanation it is certified that there is phonetic commonness or affinity among the Spanish letters put to the same key in the case of 9key keyboard arranged 3keys by 3keys.

Above mentioned is an explanation of succesive input method by 9key keyboard arranged 3keys by 3keys in the present invention.

Hereafter is shown an explanation of 15key keyboard succesively input.

18 keys are used in the above mentioned invention according to numerical formula; 3×3×2=18, while only 15 keys can be used for the 15key keyboard succesively input method according to numerical formula; 3×5=15.

The letter or letters set to each of 15 key is basically the same as that of English: a and its changed vowel, mb, cqk, d, e and its changed vowel, pf, gjh, i and its changed vowel and y, 1, n, o and its changed vowel , r, sxz, t, u and its changed vowel, and vw.

The combinations of mb, pf, and ghj are newly added to the 9key method of the present invention. This method is already utilyzed for the English , German, Italian and French input through 15key keyboard..

In the case of Spanish, precisely speaking, the phoneme for b consists of 2 types. One is a phonic bilabial occlusive sound [b] seen in lumbre, bueno, and another is phonic bilabial though not perfectly occlusive(explosive) fricative sound [β] seen in Cuba, nuevo. But this difference is not an obstacle for the present invention.
The phoneme [m] for m is a phonic nasal sound in the mode of articulation and bilabial in the position of articulation. From the standpoint of articulation, the phoneme for m and phoneme for b are both bilabial.

In the case of fp, [f] for f is an aphonic fricative sound in the mode of articulation and labio-dental in the position of articulation, while [p] for p is an aphonic occlusive(explosive) sound in the mode of articulation, so there is some extent of affinity in the nature of phoneme.

In the case of letters g and j,the phenome of the letter g is [g] when followed by vowels a, o, u, as in the case of gato, goma, gusto, and is [x] as is in the case of general, girasol. The phoneme for letter j is usually [x], which is a fricative velar sound. There is some extent of coincidence between the phoneme of letter g and the phoneme of letter j, as stated before.

H in Spanish is originally supposed to be an aphonic glottal weak fricative sound and is not pronounced nowadays.

The commonness or affinity between gj and h is not so clear, but there may be some extent of commonness or affinity between the phonemes of them. Refering to other languages, the phoneme [h] between two vowels frequently disappears in Japanese (as seen in the case: ihite→iite), and the phoneme [g] between two vowels frequently disappears in Mongolian (as seen in the case: bagator→baator). There is commonness or affinity between the phonemes in the articulation point which is situated at velar or the more inner part of the oral cavity.

The frequency of appearance of each letter or each group of letters in the Spanish Constitution and the corresponding keystrokes in the present invention with the formation of 15key keyboard arranged 3 by 5 are as follows.

(a9550, á744×2=1488, 11038 in total), (m2114, b992×2=1984, 4098 in total), (c4809, q358×2=716, k0, 5525 in total), d5153, (e11358, é170×2=340, 11698 in total), (p2501, f593×2=1186, 3687 in total), (g1021, j318×2=636, h267×3=801, 2458 in total), (i6592, y1037×2=2074, í543×3=1629, 10295 in total), 15622, (n6104, ñx2=200, 6304 in total), (07947, ó812×2=1624, 9571 in total), r6347, (s7306, z243×2=486, x117×3=351, 8143 in total), t4436, (u3104, v605×2=1210, ú135×3=405, w0, 4719 in total), Grand total is 99094.

In the case of inputing the Constitution by ordinary computer, total strokes are given by the sum of figures for each letter: a9550, b992, c4809, d5153, e11358, f593, g1021, h267, i6529, j318, k0, 15622, m2114, n6104, o7947, p2501, q358, r6347, s7306, t4436, u3104, v605, w0, x117, y1037, z243, á744, é170, é170, 1543, ó812, ú135, 90998 in total.

As Spanish 15 keyboard is not switched, the total amount of the strokes of each key is equal to the sum of strokes needed to input the Spanish Constitution.

The total amount is 99094, according to numerical formula: 11038+4098+5525+5153+11698+3687+2458+10295+5622+6304+9571+ 6347+8143+4436+4719=99094.

According to this result, the total number of keystrokes for the letters to input the Constitution of Spain is 99094, when compared with ordinary personal computer, the ratio is about 109% given by numerical formula: 99094÷90998≒1.08896.

The following is an examination of Portuguese input method selected as the fourth Latin language.

In this case, all the same with the case in the Spanish keyboard, either 9key method or 15key method is fundamentally able to adopt the same method as English one in the plan for grouping characters, with some modification.

In the case of succesive input in Portuguese through 9key keyboard, all the same as the case of English, the first letter is inputted only by one stroke, but the second letter needs two strokes and the third letter needs three strokes, so the frequency of apperance of the first letter in Portuguese should be the highest, the second for the second and the third for the third. Also, the letter or letters with high frequency in appearance in Portuguese should be put to the basic keyboard and the rest should be put to the secondary keyboard which needs another one stroke of the key to be invoked.

We shall examine the frequency of each letter appeared in the 2005 Portuguese Constitution.

The letters seen in this Constitution are as follows: a19071, b1890, c6632, d10628, e20536, f1298, g2590, h432, i13795, j436, k2, 15097, m5165, n8406, o17667, p5115, q834, r11778, s14636, t8988, u5089, v2170, w1, x402, y0, z475, ã 2067, á451, à277, â69, ê336, é329, í749, õ569, ó481, ô1, ú474, ç1939. 170874 in total.

This succesive method of inputting Portuguese in the present invention using 9key keyboard arranged 3keys by 3keys, sets 9 groups of letter or letters to the basic keyboard basically as in the English method: a and its changed vowel, e and its chaged vowel, i and its changed vowel, y, n, o and its changed vowel, r, szx, t, u and its changed vowel and vw.

Other 9 groups of letter or letters are set to the secondary keyboard: b, cqk, d, f, gj, h, l, m, p.

The frequency of appearance of each letter or letters set to each key in the Portuguese Constitution and the grand total of these figures are as follows.

Basic keyboard:(a19071, ã2067×2=4131, á451×3=1353, à277×4=1108, â69×5=345, 26011 in total), (e20536, ê336×2=672, é329×3=987, 22195 in total), (i13795, í749×2=1498, 15923 in total), n8406, (o17667, õ569×2=1138, ó481×3=1443, 20248 in total), r11778, (s14636, z475×2=950, x402×3=1206, 16792 in total), t8988, (u5089, v2170×2=4340, ú474×3=1422, w1×4=4, 10855 in total), Grand total is 140566.
Secondary keyboard: b1890, (c6632, ç1939×2=3878, q834×3=2502, k2×4=8, 13020 in total), d10628, f1298, (g2590, j436×2=872, 3462 in total), h432, 15097, m5165, p5115, Grand total is 46017.

In the case of the above mentioned Portuguese keyboard with 9keys arranged 3 by 3, the current Portuguese Constitution is inputted by the total strokes of the basic keyboard and doubled total strokes of the secondary keyboard. That is 232600 times given by numerical formula: 140566+46017×2=232600.

In the case of inputing the Constitution by ordinary computer, total strokes are given by the sum of figures for each letter: a19071, b1890, c6632, d10628, e20536, f1298, g2590, h432, i13795, j436, k2, 15097, m5165, n8406, o17667, p5115, q834, r11778, s14636, t8998, u5089, v2170, w1, x402, y0, z475, ã2067, á451, à277, â69, ê336, é329, í749, ó481, ú474, ç1939, 170874 in total.

The total number of keystrokes for the letters to input the Constitution of Portugal in the present invention is 232600, when compared to the input by ordinary personal computer, the ratio is about 136% given by numerical formula: 232600÷170874 ≒1.3612.

As seen above, in the case of 9key keyboard arranged 3keys by 3keys for Portuguese input of the present invention, the keyboard formation is quite the same as English one. If it is to be composed utterly corresponding to Portuguese phonological structure, the key for t(8898) and the key for n (8406) in the basic keyboard are to be exchnaged with the key for c çqk (13020: c4809, ç1939, q716, k0) and the key for d (10628) in the secondary keyboard.

The method of the present Portuguese keyboard concedes to Englsh method in this point. But the extent of consession is about 3.7%, according to the following numerical formula: (13020+10628-8898-8406)÷170874≒0.0366.

This invention is realized when it is certified that there is phonetic commonness or affinity among the Portuguese letters put to the same key.

In the case of a, ã, á and à, e, e and e, i and i, o õ, ó and ô, u and u, c and ç, there is similarity or affinity between vowel and its changed vowel or consonant and its changed consonant.

Also, the letter y is replaced by letter i in modern orthography. When it is rarely used for the notation of a foreign word, there is similarity or affinity seen between vowel and semi-vowel.

The letter w is not contained in the modern Portuguese alphabet and solely used for the notation of a foreign word or an abbreviated word. W is also considered to be doubled v, so there is a kind of relation between the letter v and the letter w.

Though it is rather difficult to maintain the letter v and the letter w are genuine semi-vowel, there is a kind of affinity in the position of articulation because u and w are rounded sound and v is labio-dental sound.

The letter k, along with the letter w and the letter y, is exclusively given for the notation of foreign words and seldom appears in Portuguese. It is actually possible to neglect it.

Also, the letter x is mainly given for the notation for foreign words and seldom appears in Portuguese.

Here is given an explanation as to the similarlity or affinity among the letter c, the letter ç and the letter q, accompanying the case of rare letter k with them, the letter g and the letter j, the letter s and the letter z, accompanying the case of rare letter x with them, taking their rareness given above into consideration.

In th case of the letters c, ç, k, and q, the phoneme of the letter c is [k] when followed by vowel a, o, u, as in the case of açucar, banco, documento. It is [s orθ] when followed by vowel e, i, as in the case of citade, doce. The phoneme for the letter ç is always [s orθ]. The letter k is rarely seen in Portuguese and does not appear in the current Constitution, and its phenome is [k]. Letter q is always combined with letter u and the phoneme for letters qu is [kw] and the phoneme of the letter q itself is [k].

The phoneme for letters ch is usually [∫]. This phoneme is aphonic fricative in the mode of articulation and is prepalatal in the position of articulation. The phoneme of k is aphonic occlusive (explosive) in the mode of articulation and velar in the position of articulation. There is some extent of similarity between them.

In the case of letters g and j, the phoneme of the letter g is [g] when followed by vowels a, o, u, as in the case of aga, agora, aguar, and [3] when followed by vowel i or e, as in the case of gelo, gira. The phoneme for the letter j is usually [3]. There is some extent of coincidence between the phoneme of the letter g and the phoneme of the letter j.

In th case of the letter s and the letter z, the phoneme of the letter s is usually [s], but when it is followed by phonic consonant or situated between two vowels, it is [z] as in the case of casa, desde.

The letter z is usually pronounced [z] as in the case of zona, zero, but it is [s] when situated at the end of a word, as luz.

The phoneme [s] and the phoneme [z] are both fricative in the mode of articulation and alveolar in the position of articulation, though the former is aphonic and the latter is phonic.

The letter x is mainly used for the notation of foreign words and it does not appear so often in Portuguese. Though it has many phonemes such as sexo [ks] ,peixe [∫], sexto [s], exame [z], many of them contain the phoneme [s] and the remnant has a near pronuciation to the letter s or the letter z.

With the above mentioned explanation it is certified that there is phonetic commonness or affinity among the Portuguese letters put to the same key in the case of 9key keyboard arranged 3keys by 3keys.

The above mentioned is an explanation of succesive input by 9key keyboard arranged 3keys by 3keys in the present invention.

Hereafter is an explanation of 15key keyboard succesively input.

18 keys are used in the above mentioned invention according to the numerical formula; 3×3×2=18, while 15 keys can be used for the 15key keyboard succeisively input according to numerical formula; 3×5=15.

The letter or letters set to each of 15 key is basically the same as that of English: a and its changed vowel, mb, cqk, d, e and its changed vowel, pf, gjh, i and its changed vowel and y, 1, n, o and its changed vowel , r, sxz, t, u and its changed vowel and vw.

The combinations of mb, pf, and ghj newly are added to the 9key method of the present invention. This method is already utilyzed in the case of English.

In the case of Portuguese the phoneme of the letter b is a phonic occlusive bilabial sound and the phoneme of the letter m is a phonic nasal bilabial sound. From the standpoint of the position of articulation, the phonemes for m and for b are both bilabial.

In the case of fp, [f] for f is an aphonic fricative sound in the mode of articulation and labio-dental in the position of articulation, while [p] for p is an aphonic occlusive (explosive) sound in the mode of articulation and bilabial sound in the position of articulation. So there is some extent of affinity in the nature of phoneme.

In the case of letters g and j, the phoneme [g] for letter g is a phonic occlusive sound made by the enclosure of the soft palate and lingual surface. The phoneme [3] for letter g is a phonic fricative sound made by the enclosure of the hard palate and lingual surface. The phoneme for letter j is usually [3]. There is a partial coincidence. There is also some extent of affinity between [g] and [3] in their articulation.
The letter h in Portuguese is originally supposed to be an aphonic glottal weak fricative sound and is not pronounced nowadays. The points of articulation of letters g,j,h, have some extent of affinity.

The commonness or affinity among gj and h is not so clear but there may be some extent of commonness or affinity between the phonemes of them. Refering to other languages, the phoneme [h] between two vowels frequently disappears in Japanese(as seen in the cace: ihite→iite), and the phoneme [g] between two vowels frequently disappears in Mongolian (as seen in the case: bagator→baator). There is commonness or affinity between the phonemes in the articulation point which is situated at velar or the more inner part of the oral cavity.

The frequency of appearance of each letter or each group of letters in the Portugal Constitution and the corresponding key strokes in the present invention with the formation of 15key keyboard arranged 3 by 5 are as follows.

(a19071, ã2067×2=4131, á451×3=1353, à277×4=1108, â69×5=345, 26011 in total), (c6632, ç1939×278, q834×3=2502, k2×4=8, 13020 in total), d10628, (e20536, ê336×2=672, é329×3=987, 22195 in total), (m5165, b1890×2=3780, 8945 in total), (p5115, f1298×2=2596, 7711 in total), (g2590, j436×2=872, h432×3=1296, 4758 in total), 15097, (i13795, í749×2=1498, y0, 15923 in total), n8406, (o17667, õ569×2=1138, ó481×3=1443, 20248 in total), r11778, (s14636, z475×2=950, x402×3=1206, 16792 in total), t8988, (u5089, v2170×2=4340, ú474×3=1422, w1×4=4, 10855 in total), Grand total is 190725.

As Portuguese 15 keyboard is not switched, the total amount of the strokes of each key is equal to the sum of the strokes needed to input the Portuguese Constitution. So, using the present invention of 15key method, we can input the Portuguese Constitution by 190725 strokes.

In the case of inputing the Constitution by ordinary computer, the total strokes are given by the sum of figures for each letter:17084. As is in the table below: a19071, b1890, c6632, d10628, e20536, f1298, g2590, h432, i13795, j436, k2, 15097, m5165, n8406, o17667, p5115, q834, r11778, s14636, t8988, u5089, v2170, w1, x402, y0, z475, ã2067, á451, à277, â69, ê336, é329, í749, õ569, ó481, ô1, ú474, ç1939, 170874 in grand total.

According to the above result, the total number of keystrokes for the letters to input the Constitution of Portugal in the present invention is 190725, when compared to the input by ordinary personal computer, the ratio is about 112% given by numerical formula: 190725÷170874≒1162.

Summing-up, in the switching 9key input method and fixed 15key input method of the present invention, no matter which language is chosen, German, Italian, French, Spanish, or Portuguese, it is possible to basically adopt the same grouping of letters as Englsh, by setting the changed vowel and changed consonant on the same key where is set original vowel or original consonant.

In the case of switching 9key input method, in the case of English, Italian and French as typical European languages, 9 groups of letter or letters are set to each key on the basic keyboard: the letter a and its changed vowel, the letter e and its changed vowel, the letter i and its changed vowel and y, the letter n and its changed sonsonant, the letter o and its changed vowel, the letter r, the letters sxz, the letter t, the letter u and its changed vowel and vw. Then, other 9 groups of letter or letters are set to each key on the secondary keyboard: the letter b, the letters ckq and their changed consonant, the letter d, the letter f, the letters gj , the letter h, the letter 1, the letter m and the letter p.

But this keyboard method does not thoroughly correspond with the phonetic structure in German, Spanish and Portuguese.

In the case of German it is needed to replace the letters ckq and the letter d in the secondary keyboard, with the letters oö and the letter t in the basic keyboard, to reflect German phonetic method.

In the case of Spanish it is needed to replace the letters ckq and the letter d in the secondary keyboard, with the letters uúvw and the letter t in the basic keyboard, to reflect Spanish phonetic method.

In the case of Portuguese it is needed to replace the letters ckq and the letter d in the secondary keyboard, with the letters uúvw and the letter t in the basic keyboard, to reflect Portuguese phonetic method.

But the influence brought forth by this alternation is not so big, the standard keyboard formation of the present invention is practical for all the European languages.

Now it is clear that the uniformed keyboard formation of the present invention makes it possible to input all the European languages with much more efficiency than that of the usual separate formation for each European language.

The level of input method of the present invention is nearer to the level of ordinary personal computer than that of usual portable input electronic apparatus.

The following is a summarized comparison of the efficiency of the switching 9key keyboard and the fixed 15key keyboard of the present invention with that of usual personal computer.

Putting the key strokes of usual computer as 100%, the key strokes of the succesive 9key keyboard of present invention are as follows; Italian 129.04%, French 132.55%, Spanish 133.41%, English 134.79%, Portuguese 136.12%, German 138.32%.

Putting the key strokes of usual computer as 100%, the key strokes of the fixed 15key keyboard successively input in the present invention are as follows; Italian 105.71%, Spanish 108.90%, French 109.64%, Portuguese 111.62%, English 112.02%, German 115.49%.

In a word, the present invention makes it possible to input European languages with one unified keyboard formation. In the case of the switching 9key keyboard arranged 3keys by 3keys, it is possible to input European languages by more or less 130% keystrokes of usual personal computer. In the case of fixed 15key keyboard, it is possible to input European languages by more or less 110% keystrokes of usual personal computer.

Observed from the above mentioned analysis, it seems that there is close relationship among the phonetic structure of European languages and their letter system, rather common to all of the languages.

Above mentioned previous invention insists that phonelically speaking there is a mutually complementary relationship among the letters hiy, uvw, sxz and gj in English.

Affirming this idea the present invention goes a step further. It finds a affinity or similarity of the phonemes in these letters as a base of this complementarity, and assures when these complementary letters are set to the same one key, it improves human interface of the input method.
The present invention also assumes this complementarity is seen throughout every European language; German, Italian, French, Spanish and Portuguese. From this standpoint, it proposes the uniformed style of succesive input method by 9key keyboard for all European languages, in which the letters set to the same one key are input succesively according to the succesive key strokes.

Thus, in this succesive input method for 9key keyboard and 15key keyboard, the keyboard arrangement plan is based on the affinity or commoness of the phoneme of each letter.

This idea of affinity or commoness is weaker or wider than the idea of complementarity of the previous invention. But in the process of constructing the present invention, there emerged a possibility to construct Pan-European input method based on the concept of complementarity.

The previous patent explains this concept of complementarity through the analysis of the spelling of English word, whereas the present invention starts from analyzing the nature of the phoneme of letters, which yields this comoplementarity.

That is, if we can confirm or settle the nature of the phoneme of letters, which yields this comoplementarity in English, it is possible to seak whether this phenomenon is also seen in every European language other than English. If the result is affirmative, it becomes possible to realize the second phase of the present invention; to plan Pan-European switching 9key keyboard, with which it is able to input every European language, in which every letter is input by one keystroke.

The above mentioned previous patent defines there is complementarity among each letter in the groups of letters; hiy, ckq, uvw, gj. The present invention also briefly examines the complementarity among each letter in the groups; iy, ckq, uvw and gj in English.
In the case of i and y, the letter i is vowel and the letter y is semi-vowel corresponding to the letter i.
So it is clear they have complementarity each other in the English word spelling.

That is, basically, the letter y is put at the beginning or at the end of a word, while the letter i is put in the middle of a word.

Also, basically vowels follow the letter y in the word-spelling and in many cases consonants follow the letter i in the word-spelling. There is clear complementarity between the letter i and the letter y.

In the case of uvw in English, semi-vowel w corresponds with vowel u, as seen in the naming of the letter w: double-u. There is a clear complementarity between the letter u and the letter w.

There is not such clear complementarity between the letter u and the letter v. It is common that the letter v is put at the beginning of a word and sometimes put at the end of a word in the case of the notation of foreign word, while the letter u is put basically in the middle of a word.

In the case of ckq, the letter q is always followed by the letter u and these two letters express phoneme [k] and these two letters are basically followed by vowels. There is not such case in the letter c or the lette k.

As for the relation beteen the lettercand the letter k, the phoneme of the letter c is [k] when followed by vowels a, o and u, and is [s] when followed by vowels i or e. The phoneme of the letter k is always [k].

In the case of sxz, the phoneme of the letter s is basically [s] and in the case of some verbs such as raise or cease, it takes the phoneme of [z]. The phoneme of the letter x is fundamentally [z] but there is a case of [eks], while the phoneme for the letter z is [z].

In the case of the letter g and the letter j, the phoneme of the letter g is [g] when followed by vowel a, o or u, and is [d3] followed by vowel e or i.

Referring to the above mentioned complemenarity in English, it is possible to suppose there might similar complementarity in other European languages and we actually find more clear phenomena among them.

In the case of the letter i and the letter y, we find this relation between vowel and semi-vowel all over the European languages as well as English. Moreover, the frequency of appearance of the letter y is considerably low in French, remarcably low in German, almost none in Italian and Portuguese. So when we press this key assigned for the letter i and the letter y at the same time, there might seldom happen an error in these languages other than English.

In the case of the letters u, v and w, there is some corresponding relation among them in some cases as well as in English. There is similar relation between vowel and semi-vowel all over the European languages. Moreover, except German, the letter w is rarely used in French, Italian, Spanish and Portuguese. So when we press this key assigned for the letter u, the letter v and the letter w , there might seldom happen an error in these languages except English and German.

Though German is an exception here, we can confirm this complementarity through analyzing the actual usage of the letter w in German Constitution.
In the word containing the letter u seen in the Constitution, basically the letter u is not followed by vowels. More specifically, Vowels i, o, u does not follow the vowel u. Rare exception is Weltanschauung. The vowel a seldom follows the vowel u, and rare exceptions are Januar, Notsituatioenn and Qualifizierten. In some cases the letter e follows the letter u. But in this case, the spelling appears only in the combination of auer or euer. In these spellings the letter u is not to be replaced by the letter v.

Conversely, the letters vw are not followed by consonant usually, the complementarity between them is nearly perfect.

In the case of the letter v and the letter w, it is worth notice they appear in fixed spellings: woh, weit, wieder, wider, wer for the letter w and ver vor, vier, voll for the letter v. When we replace the letter v with the letter w, the letter w with the letter v, replaced spellings are not seen in the current Constitution.
More specifically, there is no spelling in the current Constitution containing the letters voh, veit, vieder, vider. Though there are many words containing the letters ver, spelling wer is always a part of the spellling werk or werd, so there is no spelling in the current Constitution containing the letters verk or verd as a fixed partial spelling.

As for letters ver, vor, vier and voll, there are rare spellings in the current Constitution containing the letters wer, wor, wier and woll as a fixed partial spelling. In the case of wor it is always a part of the spellling wort or werd, there is only 3 spellings in the current Constitution containing the letters wort as a fixed partial spelling. In the case of wier, there is only 1 spelling Schwierigleiten in the current Constitution. Partial spelling woll does not appear in the current Constitution.

Therefore we can conclude the complementarity seen among the letters u, v and w is more clear in these European languges than in English.

In the case of letters c, k and q, the letter k is rarely used in Latin languages such as Italian, Spanish, Portuguese and French.

German is an exception in this case. But the letter c in German basically appears only in the combination of ch and ck. The letters qh and kh, or letters qk and qh, which appear when the letter c in ch and ck is replaced by the letter q or the letter k do not exist in German spelling. The complementarity between the letter c and the letters qk in German is perfect.

The letter q is always followed by the letter u and this combination of q and u makes the phoneme [k] as in English, which is followed by vowel. This kind of phenomenon is not seen with the letter c or the letter k.

In the case of the letters sxz, the letter x is rarely used in German, Italian, Portuguese and Spanish. Also, the letter z is rarely used in French. We can actually neglect these letters.

The letter s in these languages is basically pronounced [s] and sometimes pronounced [z], the same as in English.

The letter z is pronounced [z] in French and Portuguese like in English, while it is usually pronouced [ts] in German, [ds] or [ts] in Italian, and [θ] in Spanish. Though each phoneme is slightly different, all the phonemes are rather similar to the phoneme of the letter s in English.

The letter x is pronounced [ks] in German and Italian, [ks] or [s] in Spanish, [ks] or [gs] in French, [z], [∫], [s], [ks] in Portuguese. It is rarely used in any language. Also, the nature of their phoneme is similar to English.

In the case of letters gj , the phoneme of the letter g is usually [g] and sometimes the same as the phoneme of the letter j, in each of European languages.

That is, the phoneme of the letter g is usually [g] and sometimes [d3] in Italian, usually [g] and sometimes [x] in Spanish, usually [g] and sometimes [3] in Portuguese, usually [g] and sometimes [3] in French, usually [g] and sometimes [d3] in German. While the phoneme of the letter j is [d3] or [j] in Italian, is [x] in Spanish, is [s] or [j] in Portuguese, is [3] in French, is [j] and sometimes [d3] in German.

Summing up, among the letters of European languages assigned for the same key in the present invention, threre is sufficient extent of complementarity in the word spelling.

In this process of analyzing the phonological structure of European languages, it becomes clear that even in German which is realtively near to English, the complementarity among the letters cqk, letters iy and letters uvw, is almost perfect.

Here we begin to analyze the complementarity in word spelling in Italian, which seems to be most remote from English in its phonological structure and phonogramic aspect.

In the case of the letters ckq, the letter k does not exist in the original Italian alphabet. It is only used in very few cases of the notation of foreign words.

The letter q always combines with the letter u requiring a vowel just after this spelling qu. While in the case of the letter c, this sort of situation is only seen in the spellings cui and cuo.

Among these 4 spellings, cui, cuo, qui, quo, words cui and qui are very common and often apear in Italian. But as their meaning and usage are quite different, the problem is easy to be dealt with if we prepare the adequate software. Also the spelling cuo only appears in the word scuola, so it is easy to discriminate the spellinng cuo from the spellling quo.

In the case of the letters iy, the letter y does not exist in the original Italian alphabet. It is only used in very few cases of the notation of foreign words. There might not be any problem.

In the case of the letters gj, the letter j does not exist in the original Italian alphabet. It is only used in very few cases of the notation of foreign words. There might not be any problem.

In the case of letters sxz, the letter x does not exist in the original Italian alphabet. It is only used in very few cases of the notation of foreign words.

So it is neeeded to examine the complementarity between the letter s and the letter z.

The letter s appears in the current Italian Constitution 4233 times and the letter z appears 1267 times. Here is examined how many words with any meaning are brought about when these letters s and z are mutually exchanged in the current Constitution.
As the operation is so massive, 30 articles, the first quarter of the whole Constitution consisted of 139 articles, are selected as a subject of investigation.

In these articles, words containing the letter z in their spellings are as follows; giudiziaria 10 cases, nazione 8 cases, condizioni 6 cases, constituzione 5 cases, organizzazone, mezzo, limitazioni, sicurezza 4 cases each, autorizzazione, restrizione, garanzie, violazioni 3 cases each, funzione, perquisizione,ispezioni, associazioni 2 cases each, formazioni and other 41 words, 1 case each, 42 cases altogether. All the words containig the above mentioned spellings are counted here. When we exchange the letter z in these words with the letter s, only the word messo comes into existence.

Surveying the whole articles of the current Constitution, the word mezzo appears 4 times, and the word messo appears 6 times.

According to this result, it is possible to judge the complementarity between the letter s and the letter z is valid for practical use.

Surveying Italian in all, there are some cases in which this complementarity is not working, as the case in Saffo and zaffo, Sampogna and zampogna, Sara and zara, Sen and Zen, sia and zia, sizza and zizza, sic and zic. Also, both the spelling zolfo and solfo are used for the same thing. These rare cases are appropriately dealt with through refering the database.

In the case of letters uvw, the letter w does not exist in the original Italian alphabet. The letter v is a kind of semi-vowel of the vowel u.

The following is an examination on the vowel semi-vowel relation between the letter u and the letter v through confirming that the letter u is seldom followed by vowels whereas the letter v is seldom followed by consonants.

In all the words seen in the current Constitution, spellings uadi, uistiti, uomo, uovo, uopo are the whole cases where the letter u is followed by the spelling beginning with vowels, though the spelling uu is seen in abbreviation.

In all the words seen in the current Constitution, spellings sovrani and dovrà are the whole cases where the letter v is followed by consonant .There is an almost perfect complementarity between the letter u and the letter v.

According to the above mentioned examination, it is clear that the simultaneous input method for all the European languages using switching 9key keyboard, in which the letters iy, uvw, ckq, sxz, gj are set to one individual key for each group and these letters are input simultaneously by one keystroke, has sufficient practicality.
The second purpose of the present invention is thus achieved.

Being different from the succesive input method, it is necessary to prepare new dictionary database in order to put the current simultaneous input method to practical use. But once this database is provided, keystrokes needed for current portable input electronic apparatus with 9key keyboard arranged 3keys by 3keys, are much fewer than the keystrokes needed for the succesive input method. When there are some cases where complementarity is not realized, it is needed to choose correct spellings manually from the options displayed on the screen.

More specifically, in the case of this simultaneous input method of the present invention, the letters put to the same one key are input by one keystroke just the same as usual personal computer, but it is needed one more keystroke to enter secondary keyboard, so the total keystrokes of the present simultaneous method are, roughly speaking, equal to the addition of the keystrokes of usual computer to those of secondary keyboard of the present simultanous input method.

So the ratio of total strokes for the present simultanous method to those of usual personal computer is about 1.27 according to numerical formula 43151+11824=54975, 54975÷43151≒1.2740 in English.
The ratio is 1.28 according to numerical formula 136363+38103=174466, 174466÷136363≒1.2794 in German.
The ratio is about 1.25 according to numerical formula 89577+22612=112189, 112189÷89577≒1.2524 in Italian.
The ratio is about 1.24 according to numerical formula 105063+25155=130218, 130218÷105063≒1.2394 1 in French.
The ratio is about 1.27 according to numerical formula 90998+24424=115422, 115422÷90998≒1.2684 in Spanish.
The ratio is about 1.25 according to numerical formula 170874+42056=212930, 212930÷170874≒1.2461 in Portuguese. In all the cases, the ratio of the times of keystrokes in the present invention is about 125% of those by usual personal computer.

Below is given the description about the fixed 15key keyboard simultaneously input, which belongs to the second purpose of the present invention.

To begin with, we have already confirmed that it is practically useful to set the each letter group ckq, gj, iy, sxz and uvw to each one designated key to input them simultaneously in the case of switching 9key keyboard.

Also it is confirmed that it is practically useful to set changed vowels and changed consonants to the same key where the original vowel or consonant is set

Then, if we can set other 3 letters to the each separate key where is already set the letter or letters, the second purpose of the present invention in 15 key method is achieved.

But it is impossible to find any other complementarity among the phoneme of letters in European alphabet. So it is examined here whether it is possible to input simultaneously all the European languages with the above mentioned 15 key keyboard in a relatively reasonabe way.

Here is given the result of inputting simultaneously the newly added groups of letters bm, pf, ghj in each European language.

In the case of English input, it is examined how many extra keystrokes are needed when the letter b in the beginning of a word is replaced by the letter m. That is to say, how many new words appear in the case of the above mentioned exchange of the setting of the letters. Also it is examined how many extra keystrokes are needed when the letter p in the beginning of a word is replaced by the letter f. We use The Kodansha Pax English Dictionary containing about 57,500 words for setting words and use Kenkyusha's English Japanese Dictionary for the General Reader containing about 260,000 words for examining the result of the replacement.

There are about 2,700 words beginning with the letter p and there appear 131 words, face to pace, pad to fad, pair to fair, pan to fan, for example, in the case of replacement. The ratio of appearance is about 4.8%. There are about 1,900 words beginning with the letter b and there appear 204 words, bad to mad, bake to make, be to me, by to my, for example, in the case of replacement. The ratio of appearance is about 11%.

The same procedure is given to the case of g to h, j to h. In the case of g to h, there are about 1090 words beginning with letter g and there appear 71 words, gag to hag, gale to hale, gate to hate, gear to hear, for example, in the case of replacement. The ratio of appearance is about 6.5%. There are about 260 words beginning with letter j and there appear 46 words, jade to hade, job to hob, jump to hump, for example, in the case of replacement. The ratio of appearance is about 18%.

In the above given examination, all the proper nouns including the case of the notation of foreign words and all the abbreviated words, except when they are clearly determined as abbreviated one by added period, are included in the survey. Also when a word has plural meanings such as hob (flat metal shelf, male ferret) and gob (mouth, lump, sailor), we count them plurallly.

Practically the letter may appear in the middle of a word or at the end of a word, so the ratio shall be greater. But the parameter itself is not big for these letters. The times of appearance of these letters in the current Constitution of U.S.A, are as follows: m1045, b710, f1044, p813, h2216, g707, j164, 6699 times in total, which is about 15.5% of the total keystrokes of 43151 times by usual computer to input the material. So even if we assume there are 20% of duplications for all the letters, the ratio of total duplications in inputting the current Constitution is about 3% according to numerical formula: 0.155x0.2=3.1%.

The following is an examination on the frequency of appearance of these letters in German, which is relatively nearer to English than other European languages.

Here it is examined how many new words are to be added when each of the letters jgbp in the beginning of a word is replaced by each of the letters hmf in German. We use Sanseido's Daily Concise Deutch-Japanisches Wörterbuch containing about 35, 000 words for setting words and use Sanseido's Wörterbuch Deutch-Japanisch Crown containing about 60,000 words for examining the results of replacement.
There are about 264 words beginning with the letter j and there appear 8 new words in the case of replacing the letter j with the letter h. The ratio of appearance is about 3.03%. There are about 2,112 words beginning with the letter g and there appear 32 new words in the case of replacing the letter g with the letter h. The ratio of appearance is about 1.51%. There are about 1,440 words beginning with the letter m and there appear 35 new words in the case of replacing the letter m with the letter b. The ratio of appearance is about 1.66%. There are about 1,176 words beginning with the letter p and there appear 20 new words in the case of replacing the the letter p with the letter f. The ratio of appearance is about 1.70%.

There are relatively smaller numbers of inflection or conjugation in a word form in Englsh than in other European languages, so there might be larger mumbers of coincidences in other European languages which is happened to be brought forth through inflectin or conjugation. As here are only aggregated the words in their prototype shown in the dictionary, there might be a little larger numbers of coincidences in other European languages though actually negligible.

In Latin languages, several letters which are put to the same one key in the present invention are rarely used. So they are more suitable for the present invention than English and German.
Here is examined French which has relatively smaller numbers of such letters among Latin languages.

Here is examined how many new wsords are to be added when each of letters jgbp in the beginning of a word is replaced by each of the letters hmf in French. We use Taishuukan's Petit Dictionaire Standard Français-Japonais containing about 30,000 words for setting the words and use Taishuukan's Dictionaire Standard Française-Japonais containing about 60,000 words for examining the result of the replacement. There are about 300 words beginning with the letter j and there appear 4 new words in the case of replacing the letter j with the letter h. The ratio of appearance is about 1.33%. There are about 960 words beginning with the letter g and there appear 19 new words in the case of replacing the letter g with the letter h. The ratio of appearance is about 1.98%. There are about 1,500 words beginning with the letter m and there appear 68 new words in the case of replacing the letter m with the letter b. The ratio of appearance is about 4.53%. There are about 2,940 words beginning with the letter p and there appear 65 new words in the case of replacing the letter p with the letter f. The ratio of appearance is about 2.21%.

Thus we can conclude all the same with English input method, the disadvantage of the present simultaneous input method for all the European languages using 15key keyboard arranged 3keys by 5keys is not so serious.

By way of contrastive example, in the case of ordinary Japanese input or ordinary Chinese input using alphabetic letters, though word spelling and keystroke sequence always strictly corresponds, it is almost always demanded to choose a Chinese character corresponding to this word spelling or keystroke sequence manually or automatically. So we can judge that the need to choose a correct word spelling automatically from once in 10 times (the ratio of the appearance is 10%), to once in 70 times (the ratio of the appearance is 1.5%) is not a heavy burden for the method or software demanded. After all, the frequency of appearance of these letters mb, pf and hgj is considerably low in European languages.

On the contrary, it is possible to input European languages with the present 15key keyboard simultaneously input almost in the same way with usual personal computer. The merit is far bigger than the demerit.

The result of the above mentioned survey on English input shows that the loss of keystrokes caused by this simultaneous input method is very likely under 3%.
Judging from the macroscopic coincidence between the letter system and the phoneme structure seen all over the European languages, the loss of keystrokes caused by this simultaneous input method is very likely under 3% all over the European languages.

In other words, we have assumed there is high extent of homogeneity in the nature of coincidence between the letter method and the phoneme method all over the European languages. So we can conclude, practically speaking, there is scarcely any problem as to applying English simultaneous input method by 15key keyboard arranged 3keys by 5keys to all European languages.
The above mentioned fact suggests that prepared a corresponding software dictionary method it is possible to construct a method to input a word spelling by one pressing down of a key with 9key keyboard or 15key keyboard applied for all European languages.

We can divide all the languages into two types. In the European languages for example, any keystroke sequence rigidly corresponds with a given word spelling. While in some Asian languages, Japanese and Chinese for example, the keystroke sequence does not rigidly correspond with a given word character and the intended character should be chosen manually.

In the latter case, taking the method of Microsoft Windows' Office for instance, though one keystroke sequence yields plural characters, the most suitable character is chosen automatically from the point of the context or the grammatical view, which is shown on the screen as a provisional result and can be input by pressing down the space key if this choice is correct.

In the case of the present invention, the appearance of plural spellings for one keystroke is on a low level, owing to setting complemantary letters to the same one key. It is certain that the introduction of this presupposing method of Microsoft Windows' Office might improve the correspondency between the keystroke and the intended word spelling.

In other words, if there is actual complementarity between the letters, the correspondency between the keystroke and the intended word spelling is higher according to the extent of this complementarity.

The following is a brief examination on the actual complementarity seen between the letter b and the letter m, the letter p and the letter f, the letter j and the letter h, the letter g and the letter h, from the standpoint of grammar and context, which is not examined yet here.

In this examination, judging from the macroscopic coincidence between the letter system and the phoneme structure seen all over the European languages, as seen in the result of the present invention, we are going to take up the English case for example.

As is shown above, when the letter b and the letter m are input simultaneously by one keystroke with the above mentioned 15key keyboard arranged 3keys by 5keys, there appear the spellings bad and mad, bake and make, be and me, by and my, simultaneously. Here, in the rare cases of the combination of word bad and word mad, or word bake and word make, it is shared some extent of affinity in the meaning and the part of speech. Though they are quite different each other in other majority cases. So actually this sort of presupposing method by Microsoft Windows' Office is quite effective for the present invention.

As is shown above, when the letter p and the letter f are input simultaneously by one keystroke with the above mentioned 15key keyboard arranged 3keys by 5keys, there appear the spellings face and pace, pad and fad, pair and fair, pan and fan simultaneously.
Here, the word pair and the word fair are different each other in the meaning and the part of speech. In the case of other pair of words, the part of speech is the same, but the meaning is different each other.

When the letter g and the letter h are input simultaneously by one keystroke with the above mentioned 15key keyboard arranged 3keys by 5keys, there appear the spellings gag and hag, gale and hale, gate and hate, gear and hear simultaneously. Here, the word gag and the word hag is different each other in the meaning, but the part of speech is the same. In the case of other pairs of words, the part of speech and the meaning are different each other.

When the letter j and the letter h are inputted simultaneously by one keystroke with the above mentioned 15key keyboard arranged 3keys by 5keys, there appear the spellings jade and hade, job and hob, jump and hump simultaneously.
Here, the meaning of corresponding words is quite different. There is a high possibility that the correct word should be chosen according to the context through the above mentioned Office method.

We only examined some cases where plural letters are set to the same key from the standpoint of the affinity or similarity among each other. The complementarity of the phoneme is not examined here. While we know the predicting method by Micro-Office or Japanese mobile phone is actually quite useful. When there is phonetic complementarity between each letter, the predicting method might be more useful.

Through the above mentioned examination, it is possible to judge that the second phase of the present second invention is practically useful, which sets each group of letters bm, letters ckq, letters fp, letters ghj, letters iy, letters sxz, letters uvw to each one key on the 15key keyboard arranged 3keys by 5keys and the each group of letters are input simultaneously by one keystroke.

The present invention proposed the succesive input method and the simultaneous input method, both by switching 9key keyboard applying to all over the European languges. The each group of plural letters set to each key is the same in both cases. Also, the present invention proposed the succesive input method and the simultaneous input method, both by switching 15key keyboard applying to all over the European languges. The each group of plural letters set to each key is the same in both cases.

For example, in the present succesive input, in case of the key in charge of inputting the letters cçkq, the letter c is input by the first stroke, the letter k is inputted by the second stroke, the letter q is inputted by the third stroke in Englsh. While, the letter c is inputted by the first stroke, the letter ç is input by the second stroke, the letter q is input by the third stroke, the letter k is inputted by the fourth stroke in Portuguese. The choice of the letter and the order of choice are different according to the languages chosen to input.

Similarly, in case of the key in charge of inputting the letter e and the letters for changed vowels of e, nothing but the letter e is inputted by the keystroke in Englsh. While, the letter e is inputted by the first stroke, the letter e is inputted by the second stroke, the letter e is inputted by the third stroke, the letter e is input by the fourth stroke in case of French.

### BRIEF DESCRIPTION OF THE DRAWINGS

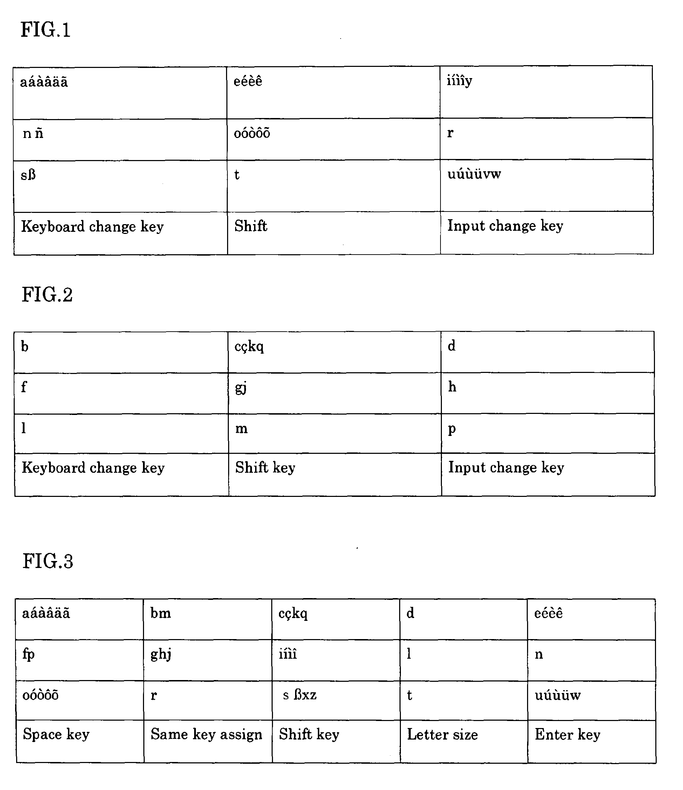

FIG.1 and FIG2 illustrate the 9key keyboard arranged 3keys by 3keys of the present invention. FIG3 illustrate the 15key keyboard arranged 3keys by 5keys of the present invention.

More specifically, FIG.1 and FIG.2 illustrate the switching 9key keyboard arranged 3keys by 3keys of the present invention. When there are changed vowels, all the changed vowels used in European languages are illustrated along with the original vowels. Also, when there are changed consonants, the changed consonants are illustrated along with the original consonants.

More specifically, FIG.3 illustrates the fixed 15key keyboard arranged 3keys by 5keys of the present invention. When there are changed vowels, all the changed vowels used in European languages are illustrated along with the original vowels. Also, When there are changed consonants, all the changed consonants are illustrated along with the original consonants.

In FIG.1, FIG.2, and FIG.3, all the letters for each key are illustrated. The illustration of the present invention intends to show the general framework for inputting all European languages, and the actual inputting is achieved through each original method for each language. As is shown above, the choice of letter and the order of choice is decided when the concerned language is chosen to input.

### APPLICABLE PRODUCTIONS

Mobilephone, Electronic Dictionary, Pocket size personal computer, various controler.

### INDUSTRIAL APPLICABILITY

In the case of usual input method of European language for electronic equipment, certain keyboard is set for certain language. The present invention offers an unified keyboard for all the European languages.
So, it is possible to input every European language reasonably so long as the needed software is equipped with. It brings forth an easy exchange of information all over the European countries.

The present invention realized a high operability in portable input electronic apparatus quite different from the usual one and rather near to ordinary personal computer.

As numbers of keys and the times of keystrokes are reduced in the present invention, it might also contribute to improve the touch-screen input method whose operability is relatively unstable.

Judging from the above mentioned operability of the present invention, there are several prospective views. Firstly, an effective area is more enlarged than usual personal computer and the accessibility to the system is better than usual mobile phone, which shall increase the numbers of users and enlarge the situation for information technology.

Secondly, the present invention breaks down the limitation of time and place compared to using relatively big ordinary personal computer. The exchange of information and data searching become much easier for users, closely related to the daily life of users. New portable input electronic apparatus can be comparable to the pocket book in old days.

Nowadays the phase of international communications is remarkably expanded, but the relatively troublesome method of usual mobile phone can not sufficiently bear the charge and almost all the important work is done by personal computer.

We expect the present invention can break down this limitation and the international personal exchange and information exchange shall remarkably develop.

Portable input electronic apparatus, most of all mobile phone engages in daily exchange of information and data, So the the improvement of human interface of portable input electronic apparatuss by the present invention shall contribute to this every day communication.

As is explained above, the present invention has a potentiality to bring forth a transformation of the industrial structure and the human relations.

## Claims

1. A method for inputting Western European languages through alphabet in portable electronic apparatus wherein plural letters are assigned to single key, the method comprising:
identifying combinations of the plural letters of one language which are commonly used for other Western European languages,
wherein the plural letters of which the phonemes the character takes charge of is identical or sometimes identical or near;
and
assigning each combination to a key unified in all Western European languages for inputting the combination of plural letters, so as to input every European language through unified keyboard.

2. The method of claim 1, wherein plural letters assigned to single key are inputted according to the order of their frequency of the appearance in the language chosen to input so that the first key stroke yields the letter seen most frequent in given lannguage, the second key stroke yields the second frequent lettter and third for third, fourth for fourth.

3. The method of claim 1, wherein plural letters assigned to single key are inputted simultaneously by one stroke of the key.

4. The method of claim 1, wherein the keyboard is composed of two virtual keyboards, each one of which contains 9 keys arranged 3rows by 3columns and manually switched,
5 keys are assingned 5 groups of letters each group of which is composed of letters ckq, gj, iy, sxz, and uvw.

5. The method of claim 1, wherein the keybooad is composed of two virtual keyboards, each one of which contains 9 keys arranged 3rows by 3columns and manually switched,
whose 5 keys are assingned 5 groups of letters each group of which is composed of letters ckq, gj , i and its changed letters and y, n and its changed consonnant, s and its changed consonnant and xz, u and its changed vowels and vw, and the first main virtual keyboard which is used in the beginning of input is equipped with 9 keys which are assigned 9 groups of letters each group of which is composed of letters: a and its changed vowels, e and its changed vowels, i and its changed vowels and y, n and its changed consonnant, o and its changed vowels, s and its changed cononnant and xz, t, u and its changed vowels and vw, and the second minor virtual keyboard is equipped with 9 keys which are assigned 9 groups of letters each group of which is composed of other alphabet letters : b, c and its changed consonnant and kq, d, f, gj, h, l, m, p.

6. The method of claim 1, wherein the keyboard contains 15 keys arranged 3rows by 5 columns, 7 keys are assingned 7 groups of letters each group of which is composed of letters c and its changed letter and kq, gj, i and its changed letter and y, s and its changed letter and xz, u and its changed letter and vw, pf, mb.

## Amended claims

### Amended claims under Art. 19.1 PCT

**1.** A method for inputting Western European languages through alphabet in portable electronic apparatus and a method wherein plural letters are assigned to single key, the method comprising: setting up the method applied to all the Western European languages wherein certain keys are assigned plural letters in which each key is assigned certain letters complimentary in spelling and in which each key for vowel is also assigned its accented vowels and changed vowels and certain key for consonant is also assigned its changed consonant, so as to input every European language through unified keyboard.

**2.** The method of claim 1, wherein plural letters assigned to single key are inputted according to the order of their frequency of the appearance in the language chosen to input so that the first key stroke yields the letter seen most frequent in given language, the second key stroke yields the second frequent letter and third for third, fourth for fourth.

**3.** The method of claim 1, wherein plural letters assigned to single key are inputted simultaneously by one stroke of the key.

**4.** The method of claim 1, wherein the keyboard is composed of two virtual keyboards, each one of which contains 9 keys arranged 3rows by 3columns and manually switched,
5 keys are assigned 5 groups of letters each group of which is composed of letters ckq, gj, iy, sxz, and uvw.

**5.** The method of claim 1, wherein the keyboard is composed of two virtual keyboards, each one of which contains 9 keys arranged 3rows by 3columns and manually switched,
whose 5 keys are assigned 5 groups of letters each group of which is composed of letters ckq, gj , i and its changed letters and y, n and its changed consonant, s and its changed consonant and xz, u and its changed vowels and vw, and the first main virtual keyboard which is used in the beginning of input is equipped with 9 keys which are assigned 9 groups of letters each group of which is composed of letters: a and its changed vowels, e and its changed vowels, i and its changed vowels and y, n and its changed consonant, o and its changed vowels, s and its changed consonant and xz, t, u and its changed vowels and vw, and the second minor virtual keyboard is equipped with 9 keys which are assigned 9 groups of letters each group of which is composed of other alphabet letters : b, c and its changed consonant and kq, d, f, gj, h, l, m, p.

**6.** The method of claim 1, wherein the keyboard contains 15 keys arranged 3rows by 5 columns,7 keys are assigned 7 groups of letters each group of which is composed of letters c and its changed letter and kq, gj, i and its changed letter and y, s and its changed letter and xz, u and its changed letter and vw, pf, mb.
